(19) Europäisches Patentamt
European Patent Office
Office européen des brevets

(11) **EP 4 226 169 B1**

(12) **FASCICULE DE BREVET EUROPEEN**

(45) Date de publication et mention
de la délivrance du brevet:
**16.10.2024 Bulletin 2024/42**

(21) Numéro de dépôt: **21807194.2**

(22) Date de dépôt: **21.10.2021**

(51) Classification Internationale des Brevets (IPC):
**G01R 33/02** *(2006.01)* **H02H 1/00** *(2006.01)*

(52) Classification Coopérative des Brevets (CPC):
**H02H 5/044;** G01R 33/0076; G01R 33/0206;
G01R 33/0286; H01H 2011/0068; H01H 2071/044

(86) Numéro de dépôt international:
**PCT/FR2021/051847**

(87) Numéro de publication internationale:
**WO 2022/090648 (05.05.2022 Gazette 2022/18)**

(54) **PROCÉDÉ ET DISPOSITIF DE CONTRÔLE DE L'ETAT DE FONCTIONNEMENT DE DISJONCTEURS**

VERFAHREN UND VORRICHTUNG ZUR ÜBERWACHUNG DES BETRIEBSZUSTANDES VON SCHUTZSCHALTERN

METHOD AND DEVICE FOR MONITORING THE OPERATING STATUS OF CIRCUIT BREAKERS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **02.11.2020 FR 2011228**

(43) Date de publication de la demande:
**16.08.2023 Bulletin 2023/33**

(73) Titulaire: **Smartfuture**
**83390 Pierrefeu du Var (FR)**

(72) Inventeur: **BERTRAND, Paul**
**833940 PIERREFEU DU VAR (FR)**

(74) Mandataire: **Marchand, André et al**
**Omnipat**
**610, chemin de Fabrègues**
**13510 Éguilles (FR)**

(56) Documents cités:
**EP-A1- 2 637 027 CN-A- 107 978 495**
**US-A1- 2018 070 897**

EP 4 226 169 B1

**Description**

La présente invention concerne un procédé et un dispositif pour contrôler l'état de fonctionnement d'un ensemble de disjoncteurs.

Il est connu qu'une élévation excessive de la température d'un disjoncteur est le signe d'un défaut électrique et peut être annonciatrice d'une panne future pouvant conduire à la destruction du disjoncteur et par conséquent la mise à l'arrêt intempestive de l'équipement que le disjoncteur alimente électriquement. Dans le cas d'installations commerciales ou industrielles, une telle mise à l'arrêt d'un équipement, par exemple un groupe frigorifique ou un système de surveillance d'incendie, peut entraîner des pertes de production et des pertes financières significatives, ou affecter la sécurité des installations. Une température élevée d'un disjoncteur peut être significative d'un défaut interne du disjoncteur, d'une erreur de câblage, par exemple le mauvais serrage d'un fil d'alimentation électrique, d'une mauvaise installation du tableau électrique, par exemple l'usage de fils électriques de trop faible diamètre, ou encore d'un défaut de l'équipement alimenté électriquement par le disjoncteur, se traduisant par la circulation d'un courant élevé sans pour autant provoquer la rupture du disjoncteur. Il est donc particulièrement recommandé de procéder de temps en temps à une vérification de l'état d'un ensemble de disjoncteurs par une mesure de leurs températures.

Il existe à cet effet diverses techniques dites "non intrusives", telle que la vidéo thermique, qui ne fournissent qu'un état instantané de la température d'un disjoncteur et ne permettent pas un contrôle permanent de celle-ci. Ces techniques nécessitent de plus des installations coûteuses ou l'intervention sur site de techniciens spécialisés, qui s'avère tout aussi coûteuse.

Il peut donc être souhaité de prévoir un moyen simple et peu coûteux permettant de surveiller la température d'un ensemble de disjoncteurs dans des intervalles de temps réduits, par exemple de l'ordre de quelques secondes, afin d'anticiper l'apparition de problèmes.

Le document EP2637027 décrit un procédé et un dispositif de mesure du courant traversant un disjoncteur comportant une bobine de protection et une paroi traversée par un champ magnétique émis par la bobine de protection. Selon ce procédé, on agence sur la paroi du disjoncteur un magnétomètre numérique triaxial synchrone sur microplaquette de semi-conducteur. Au moyen du magnétomètre, au moins une composante du champ magnétique émis par la bobine de protection est mesurée, pour en déduire la valeur d'un courant traversant le disjoncteur. Dans un tableau électrique comprenant un ensemble de disjoncteurs, un magnétomètre est agencé sur chaque disjoncteur, ce qui permet de mesurer le courant ligne par ligne et donc de surveiller la consommation électrique de l'installation poste par poste.

Il peut également être souhaité de prévoir un moyen permettant de suivre l'évolution dans le temps de la température d'un ensemble de disjoncteurs équipé d'un tel dispositif de mesure individuelle de courant.

Ainsi, des modes de réalisation de l'invention concernent un procédé pour contrôler l'état de fonctionnement d'un ensemble de disjoncteurs, chaque disjoncteur comprenant une bobine de protection et présentant une paroi traversée par un champ magnétique émis par la bobine, le procédé comprenant l'étape consistant à : agencer sur la paroi de chaque disjoncteur un magnétomètre numérique triaxial synchrone sur microplaquette de semi-conducteur, chaque magnétomètre comprenant des moyens de mesure de champ magnétique et un capteur de température interne, et une sortie de données pour fournir des mesures de champ magnétique et de température ; lire cycliquement et de manière synchrone, à des instants successifs, les températures fournies par les magnétomètres ; à partir des températures mesurées par les magnétomètres et d'une valeur de la température ambiante, déterminer, pour chaque disjoncteur, si une température d'échauffement interne du disjoncteur atteint un premier seuil de température pouvant être représentatif d'une anomalie de l'état de fonctionnement du disjoncteur ; et émettre une alarme d'un premier type lorsque la température d'échauffement interne d'au moins un disjoncteur atteint le premier seuil de température.

Selon un mode de réalisation, la valeur de la température ambiante est estimée à partir des températures mesurées par les magnétomètres.

Selon un mode de réalisation, la valeur de la température ambiante est choisie parmi l'une des valeurs suivantes : une valeur moyenne des températures mesurées au même instant par les magnétomètres, une valeur moyenne pondérée des températures mesurées au même instant par les magnétomètres, la plus basse des températures mesurées au même instant par les magnétomètres, ou une combinaison d'au moins deux des trois valeurs précédentes.

Selon un mode de réalisation, le procédé comprend au moins la première des deux étapes suivantes : pour chaque magnétomètre et disjoncteur associé au magnétomètre, soustraire la valeur de température ambiante à chaque température mesurée par le magnétomètre, pour l'obtention d'une première estimation de la température d'échauffement interne du disjoncteur ; et pour chaque magnétomètre et disjoncteur associé au magnétomètre, soustraire à chaque première estimation de la température d'échauffement interne du disjoncteur, la valeur moyenne d'une pluralité d'estimations de la température d'échauffement interne du disjoncteur calculées à des instants différents, pour l'obtention d'une seconde estimation de la température d'échauffement interne du disjoncteur.

Selon un mode de réalisation, le procédé comprend les étapes consistant à déterminer, pour chaque disjoncteur, si la température d'échauffement interne du disjoncteur atteint un second seuil de température, et émettre une alarme d'un deuxième type si la température d'échauffement interne atteint un second seuil de température supérieur au premier seuil de température.

Selon un mode de réalisation, le procédé comprend les étapes consistant à lire cycliquement et de manière synchrone, à des instants successifs, les valeurs d'au moins une composante du champ magnétique mesurée par chaque magnétomètre, représentative du champ émis par la bobine du disjoncteur auquel chaque disjoncteur est associé, et évaluer la valeur d'un courant traversant chaque disjoncteur à partir de la composante du champ magnétique mesurée.

Selon un mode de réalisation, l'alarme du premier type n'est émise que si le disjoncteur est traversé par un courant inférieur à un seuil de courant pour lequel sa température d'échauffement interne ne devrait pas dépasser le premier seuil de température.

Selon un mode de réalisation, lorsque les températures d'échauffement interne de deux disjoncteurs contigus atteignent chacune le premier seuil de température, l'alarme du premier type n'est pas émise pour celui des deux disjoncteurs qui n'a été traversé par aucun courant pendant un temps déterminé.

Selon un mode de réalisation, le procédé comprend les étapes consistant à, pour chaque disjoncteur : évaluer de manière cyclique le courant traversant le disjoncteur ; évaluer, dans une fenêtre temporelle d'observation d'une durée de quelques heures à quelques jours, un taux de fonctionnement du disjoncteur qui est fonction du nombre de périodes où le disjoncteur est traversé par un courant, et de la durée de chacune de ces périodes; surveiller la variation du taux de fonctionnement du disjoncteur à l'intérieur de la fenêtre temporelle d'observation ; et émettre une alarme d'un troisième type indiquant une possibilité de dysfonctionnement d'un équipement alimenté électriquement par le disjoncteur si la variation du taux de fonctionnement du disjoncteur dépasse un seuil de variation déterminé.

Selon un mode de réalisation, le procédé comprend, lorsque les conditions d'émission de l'alarme du premier type sont réunies pour deux disjoncteurs contigus, une étape consistant à comparer les taux de fonctionnement de chaque disjoncteur pour identifier le disjoncteur ayant la plus forte probabilité d'anomalie de son état de fonctionnement, l'élévation de la température de l'un des disjoncteurs pouvant être causée par l'élévation de la température de l'autre disjoncteur, et dans lequel l'alarme du premier type n'est émise que pour le disjoncteur ayant la plus forte probabilité d'anomalie de son état de fonctionnement.

Selon un mode de réalisation, l'émission d'une alarme comprend l'une des actions suivantes ou une combinaison des actions suivantes : afficher une information sur un écran de contrôle, envoyer un message électronique à un destinataire, activer un voyant lumineux ou déclencher une alarme sonore.

Des modes de réalisation de l'invention concerne également un dispositif pour contrôler l'état de fonctionnement d'un ensemble de disjoncteurs, chaque disjoncteur comprenant une bobine de protection et présentant une paroi traversée par un champ magnétique émis par la bobine, le dispositif comprenant un ensemble de magnétomètres numériques triaxiaux synchrones sur microplaquettes de semi-conducteur, chaque magnétomètre étant agencé sur la paroi d'un disjoncteur et comprenant des moyens de mesure de champ magnétique, un capteur de température interne et une sortie de données pour fournir des mesures de champ magnétique et de température, et un circuit de contrôle relié aux magnétomètres, dans lequel le circuit de contrôle est configuré pour : lire cycliquement et de manière synchrone, à des instants successifs, les températures mesurées par les magnétomètres ; à partir des températures mesurées par les magnétomètres et d'une valeur de la température ambiante, déterminer, pour chaque disjoncteur, si une température d'échauffement interne du disjoncteur atteint un premier seuil de température pouvant être représentatif d'une anomalie de l'état de fonctionnement du disjoncteur ; et émettre une alarme d'un premier type lorsque la température d'échauffement interne d'au moins un disjoncteur atteint le premier seuil de température.

Selon un mode de réalisation, le circuit de contrôle est configuré pour estimer la valeur de la température ambiante à partir des températures mesurées par les magnétomètres.

Selon un mode de réalisation, le circuit de contrôle est configuré pour exécuter au moins la première des deux étapes suivantes, pour chaque magnétomètre et disjoncteur associé au magnétomètre : soustraire la valeur de température ambiante à chaque température mesurée par le magnétomètre, pour l'obtention d'une première estimation de la température d'échauffement interne du disjoncteur ; soustraire à chaque première estimation de la température d'échauffement interne du disjoncteur, la valeur moyenne d'une pluralité d'estimations de la température d'échauffement interne du disjoncteur calculées à des instants différents, pour l'obtention d'une seconde estimation de la température d'échauffement interne du disjoncteur.

Selon un mode de réalisation, le circuit de contrôle est configuré pour émettre en sus de l'alarme du premier type, une alarme d'un deuxième type lorsque la température d'échauffement interne d'au moins un disjoncteur atteint un second seuil de température supérieur au premier seuil de température.

Selon un mode de réalisation, le circuit de contrôle est configuré pour : lire cycliquement et de manière synchrone, à des instants successifs, les valeurs d'au moins une composante du champ magnétique mesurée par chaque magnétomètre, représentative du champ émis par la bobine du disjoncteur auquel chaque disjoncteur est associé, et évaluer la valeur d'un courant traversant chaque disjoncteur à partir de la composante du champ magnétique mesurée.

Selon un mode de réalisation, le circuit de contrôle est configuré pour n'émettre l'alarme du premier type que si le disjoncteur est traversé par un courant inférieur à un seuil de courant pour lequel sa température d'échauffement interne ne devrait pas dépasser le premier seuil de température.

Selon un mode de réalisation, lorsque les températures d'échauffement interne estimées de deux disjoncteurs contigus atteignent chacune le premier seuil de température, le circuit de contrôle est configuré pour ne pas émettre l'alarme du premier type pour celui des deux disjoncteurs qui n'a été traversé par aucun courant pendant un temps déterminé.

Selon un mode de réalisation, le circuit de contrôle est configuré pour exécuter les étapes suivantes, pour chaque disjoncteur : évaluer de manière cyclique le courant traversant le disjoncteur ; calculer, dans une fenêtre temporelle glissante d'observation au moins égale aux dernières 24 heures, un taux de fonctionnement du disjoncteur qui est fonction du nombre de périodes où le disjoncteur est traversé par un courant, et de la durée de chacune de ces périodes ; surveiller la variation du taux de fonctionnement du disjoncteur au fil du temps, dans la fenêtre temporelle glissante d'observation ; et émettre une alarme d'un troisième type si la variation du taux de fonctionnement du disjoncteur dépasse un seuil de variation déterminé.

Selon un mode de réalisation, lorsque les conditions d'émission de l'alarme du premier type sont réunies pour deux disjoncteurs contigus, le circuit de contrôle est configuré pour comparer les taux de fonctionnement de chaque disjoncteur pour identifier le disjoncteur ayant la plus forte probabilité d'anomalie de son état de fonctionnement, l'élévation de la température de l'un des disjoncteurs pouvant être causée par l'élévation de la température de l'autre disjoncteur, et n'émettre l'alarme du premier type que pour le disjoncteur ayant la plus forte probabilité d'anomalie de son état de fonctionnement.

Selon un mode de réalisation, le circuit de contrôle est configuré pour émettre une alarme en exécutant l'une des actions suivantes ou une combinaison des actions suivantes : afficher une information sur un écran de contrôle, envoyer un message électronique à un destinataire, activer un voyant lumineux ou déclencher une alarme sonore.

Des modes de réalisation d'un procédé et d'un dispositif de contrôle de l'état de fonctionnement de disjoncteurs seront décrits dans ce qui suit à titre non limitatif, en relation avec les figures jointes, parmi lesquelles :

- [fig. 1] : la figure 1 montre un ensemble de modules de contrôle selon l'invention, pour le contrôle de disjoncteurs,

- [fig. 2A][fig. 2B] : les figures 2A, 2B sont des vues en perspective et de profil d'un ensemble de disjoncteurs recevant les modules de contrôle de la figure 1,

- [fig. 3] : la figure 3 est le schéma électrique d'un dispositif de contrôle comprenant de tels modules de contrôle,

- [fig. 4] : la figure 4 illustre un algorithme de contrôle de disjoncteurs mis en oeuvre par le dispositif de la figure 3,

- [fig. 5] : la figure 5 est un organigramme montrant des étapes de calcul de l'algorithme de contrôle de disjoncteurs de la figure 4,

- [fig. 6] : la figure 6 est le schéma électrique d'une variante du dispositif de contrôle de la figue 3,

- [fig. 7] : la figure 7 illustre un algorithme de contrôle de disjoncteurs mis en oeuvre par le dispositif de la figure 6,

- [fig. 8] la figure 8 est un organigramme montrant des étapes de calcul de l'algorithme de contrôle de la figure 7,

- [fig. 9] : la figure 9 montre un disjoncteur et les composantes d'un champ magnétique émis par la bobine de protection du disjoncteur,

- [fig. 10] : la figure 10 illustre une étape d'un procédé de correction d'interférence magnétique entre disjoncteurs.

Des modes de réalisation de la présente invention incluent l'observation selon laquelle il existe, sur le marché, des magnétomètres numériques triaxiaux conçus pour mesurer le champ magnétique terrestre, tels que ceux destinés au marché des téléphones mobiles pour mettre en oeuvre des applications de type boussole logicielle, détecteur de métal, analyseur d'argent pur, etc. Ces magnétomètres à base de MEMS (systèmes microélectromécaniques) sont intégrés sur une puce de semi-conducteur et comportent, en sus de capteurs du champ magnétique terrestre, un capteur de température interne configuré pour mesurer la température de la microplaquette de semi-conducteur sur laquelle ils sont intégrés. De tels magnétomètres comportent également un circuit d'interface de communication apte à dialoguer avec un contrôleur externe par l'intermédiaire d'un bus de données, pour fournir des mesures de température et de champ magnétique. De tels magnétomètres peuvent effectuer des mesures synchrones de température et des mesures synchrones de champ magnétique, grâce à une entrée de synchronisation prévue pour recevoir un signal de synchronisation externe.

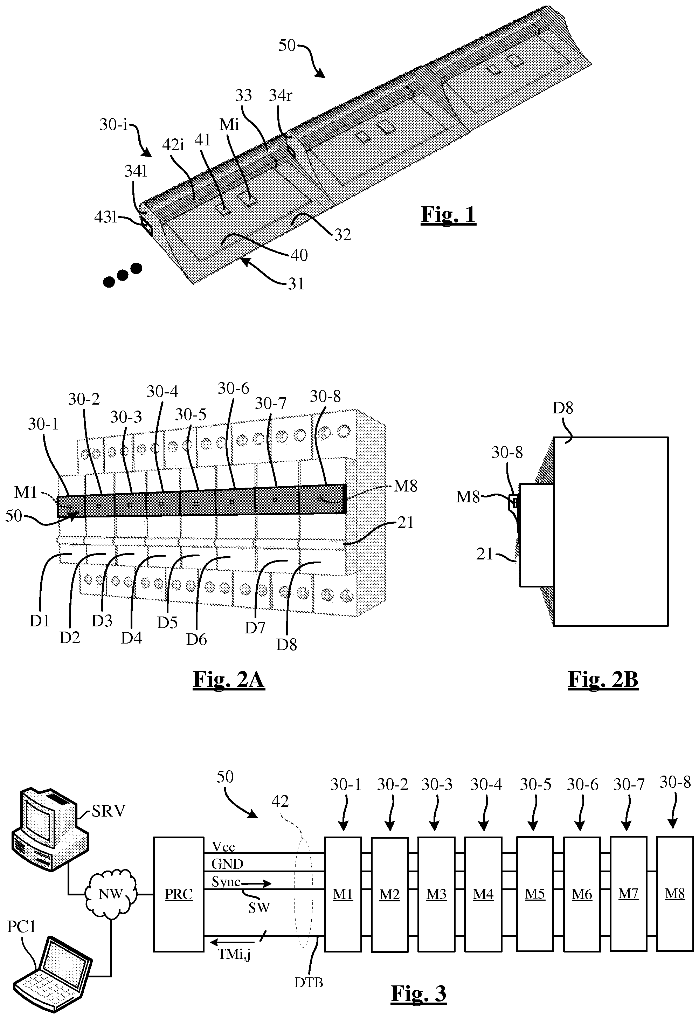

La figure 1 représente un ensemble de modules de contrôle 30-i d'un dispositif 50 de contrôle selon l'invention, réalisés à partir de tels magnétomètres synchrones triaxiaux. Les modules de contrôle 30-i sont identiques et agencés les uns à côté des autres. Chaque module 30-i comporte un boîtier 31 comprenant un socle 32, un capot 33 s'étendant dans le prolongement du socle 32 et recouvrant partiellement celui-ci, une paroi latérale gauche 341 et une paroi latérale droite 34r. Un circuit imprimé 40 est agencé sur le socle 32. Le circuit imprimé 40 reçoit un magnétomètre numérique triaxial $M_i$, les contacts du boîtier du magnétomètre étant soudés sur des plages de contact du circuit imprimé (non représentées). Alternativement, le magnétomètre $M_i$ peut être monté en "puce nue" sur le circuit imprimé. Le circuit imprimé reçoit également des composants électroniques auxiliaires représentés schématiquement sous la forme d'un bloc 41, par exemple des condensateurs et des résistances. Les magnétomètres $M_i$ sont par exemple ceux commercialisés par la société STMicroelectronics sous la référence LIS3MDL. Ils comprennent deux registres de capteur de température d'adresses 2Eh et 2Fh fournissant une mesure de température en deux parties pouvant être lue avec des commandes "TEMP_OUT_L (2Eh)" et "TEMP_OUT_H (2Fh)".

Chaque module 30-i comporte des pistes conductrices transversales 42-i, réalisées par exemple sur le circuit imprimé 40. Ces pistes transversales sont recouvertes par un cache de protection dans l'exemple représenté. Le magnétomètre $M_i$ est relié électriquement aux pistes conductrices transversales 42-i par l'intermédiaire de pistes conductrices du circuit imprimé (non représentés). Les pistes conductrices transversales 42-i sont reliées électriquement à un connecteur gauche 431 et à un connecteur droit (non représenté) du module 30-1. Le connecteur gauche 431 traverse la paroi latérale gauche 341 et le connecteur droit traverse la paroi latérale droite 34r. Chaque connecteur 43I coopère ou peut coopérer électriquement avec le connecteur correspondant d'un module contigu 30-(i+1) ou 30-(i-1), de manière que les pistes conductrices transversales 42-i des différents modules soient interconnectées et forment, ensemble, un bus de données et d'alimentation 42 auquel tous les magnétomètres $M_i$ sont reliés.

Les figures 2A et 2B représentent, respectivement par une vue en perspective et de profil, un mode de réalisation du dispositif de contrôle 50 comprenant ici huit modules 30-i (30-1 à 30-8) comportant chacun un magnétomètre $M_i$ (M1 à M8). Les modules 30-i sont disposés sur un ensemble de huit disjoncteurs $D_i$ (D1 à D8) agencés côte à côte dans un tableau électrique, contrôlant des branches d'un réseau électrique. Comme on le voit sur la figure 2B, la face arrière du socle de chaque module 30-i (30-8 sur la figure) est fixée sur la face avant ("petite face") d'un disjoncteur $D_i$ (D8 sur la figure), au-dessus du levier de réarmement 21, par exemple au moyen d'un adhésif double face choisi de préférence pour offrir une bonne conductivité thermique.

La forme ouverte du boîtier de chaque module $M_i$ permet de passer le doigt au-dessus du circuit imprimé, pour le réarmement d'un disjoncteur, les modules 30-i étant agencés au-dessus du levier de réarmement 21. Le levier de réarmement 21 montré sur la figure 2B en position basse, se trouve après réarmement du disjoncteur dans une position haute où il s'étend au-dessus du circuit imprimé du module $M_i$ (M8 sur la figure).

La figure 3 est un schéma bloc de l'architecture électrique du dispositif 50, montrant d'autres éléments de celui-ci. On distingue les huit modules de contrôle 30-i (30-1 à 30-8) équipé chacun d'un magnétomètre $M_i$ (M1 à M8), les magnétomètres étant interconnectés par le bus de données et d'alimentation 42. Le bus 42 comprend un bus de données DTB incluant un fil d'horloge, un fil de synchronisation SW et des fils de masse GND et d'alimentation Vcc. Le fil de synchronisation SW permet d'appliquer aux magnétomètres un signal de synchronisation Sync, pour déclencher la mesure simultanée des températures $TM_{i,j}$ des magnétomètres $M_i$ à des instants $T_j$.

Chaque magnétomètre $M_i$ est relié par l'intermédiaire du bus 42 à un processeur PRC, par exemple un microcontrôleur. Le processeur PRC peut être logé dans un des modules de contrôle 30-i, qui forme alors à la fois un module de contrôle et un module maître assurant le contrôle des autres modules. Alternativement un module de contrôle spécifique équipé du processeur PRC peut être prévu. Le module de contrôle est agencé en un point quelconque du tableau électrique et est connecté aux modules $M_i$ par l'intermédiaire du connecteur gauche 43I du premier module 30-1 ou du connecteur droit du dernier module 30-8. Le processeur PRC fournit le signal de synchronisation Sync aux magnétomètres $M_i$ et reçoit de ceux-ci, à des instants successifs $T_j$ définis par le signal Sync, par exemple toutes les 3 secondes, les températures mesurées par les capteurs de température des magnétomètres. Ces températures, qui sont celles de la puce de silicium des magnétomètres, seront notées $TM_{i,j}$, "i" étant le rang d'un magnétomètre et "j" le rang de la mesure de température sur une échelle temporelle définie par le signal Sync.

Le dispositif 50 comprend également, optionnellement, un serveur SRV auquel le processeur PRC est relié par l'intermédiaire d'un réseau NW, par exemple le réseau Internet. Les températures $TM_{i,j}$ collectées par le processeur PRC sont traitées au moyen d'un algorithme de contrôle de l'état de fonctionnement de chaque disjoncteur. Cet algorithme est exécuté par le processeur PRC ou par le serveur SRV, ou en partie par le processeur PRC et en partie par le serveur. Dans des conditions de mise en oeuvre ne permettant pas une connexion fiable avec le serveur, l'exécution de l'algorithme par le processeur PRC pourra être privilégiée. Le serveur SRV peut par ailleurs être configuré pour gérer des comptes d'abonnés auxquels les utilisateurs se connectent via Internet avec des ordinateurs personnels PC1, pour avoir accès à un ensemble d'informations sur l'état de fonctionnement des disjoncteurs de leur réseau électrique.

Dans ce qui suit, il sera considéré dans un souci de simplification de la description que l'intégralité de l'algorithme de contrôle est exécuté par le serveur SRV, le processeur assurant uniquement des tâches de synchronisation des modules 30-1, de collecte des températures $TM_{i,j}$ et de transmission de celles-ci au serveur.

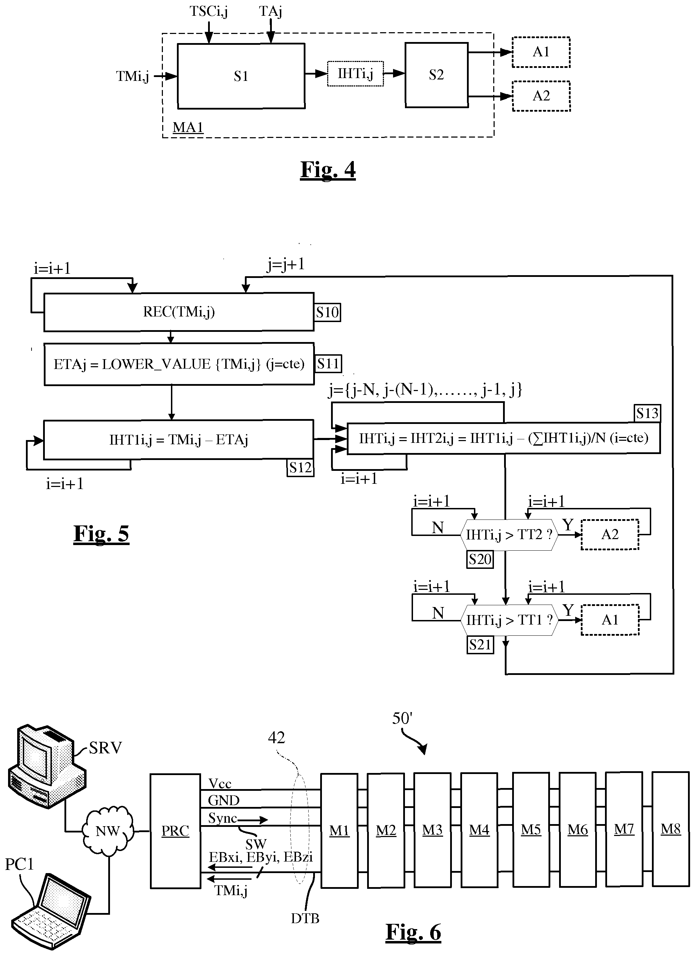

Selon un mode de réalisation MA1 de l'algorithme schématisé sur la figure 4, les températures $TM_{i,j}$ sont analysées par le serveur SRV pour détecter un échauffement anormal d'au moins un des disjoncteurs. L'algorithme MA1 comprend une phase d'analyse S1 et une phase de décision S2. La phase d'analyse S1 consiste à estimer les températures d'échauffement interne des disjoncteurs $IHT_{i,j}$. Ces températures $IHT_{i,j}$ sont estimées à partir des températures $TM_{i,j}$ mesurées par les magnétomètres et d'une valeur de la température ambiante.

La phase de décision S2 vise à décider, à partir des températures d'échauffement interne $IHT_{i,j}$ des disjoncteurs, si des alarmes doivent être émises. Dans un mode de réalisation, le serveur émet une alarme A1 d'un premier type lorsque la température d'échauffement interne d'un disjoncteur atteint le premier seuil de température TT1, et émet une alarme A2 d'un second type lorsque la température d'échauffement interne d'un disjoncteur atteint un seuil de température TT2 supérieur au seuil de température TT1. L'alarme A1 est par exemple émise lorsque la température d'échauffement interne du disjoncteur est telle qu'une intervention technique doit être conseillée. L'alarme A2 est par exemple émise lorsqu'il est estimé qu'un disjoncteur nécessite une intervention urgente.

Cette émission d'une ou de plusieurs alarmes repose sur la connaissance du fait qu'une augmentation de la température d'échauffement interne d'un disjoncteur, même si elle n'est pas excessivement élevée, peut être indicative d'une défaillance et/ou peut être annonciatrice d'une défaillance plus grave. Pour choisir les seuils des alarmes A1, A2, on pourra se référer au tableau 1 ci-après, qui décrit plusieurs situations possibles.

[Tableau 1]

| Température d'échauffement interne d'un disjoncteur | Action recommandée |
|---|---|
| 1°C - 10°C | Défaillance possible, justifie des investigations |
| 11°C - 20°C | Défaillance possible, réparation ou investigation conseillée lorsque le planning le permet |
| 21°C - 40°C | Mettre le composant sous surveillance jusqu'à ce que des mesures correctives puissent être prises |
| > 40°C | Défaillance majeure, réparation immédiate nécessaire |

Pour la mise en oeuvre de l'algorithme MA1, le seuil de température TT1 pour l'émission de l'alarme A1 est choisi en fonction des exigences de l'application, et pourra être par exemple compris entre 11° C et 40°C, cette valeur représentant un écart par rapport à la température ambiante. Le seuil TT2 pour l'émission de l'alarme A2 sera par exemple 40°C, signifiant qu'un disjoncteur encourt un risque de combustion, cette valeur représentant également ici un écart par rapport à la température ambiante. Les valeurs des seuils de température TT1, TT2 peuvent être modulées en fonction de l'environnement, de la dangerosité du site (présence de gaz inflammables par exemple), etc.

L'émission d'une alarme, selon le degré d'alerte auquel elle correspond, peut consister en une ou plusieurs des actions suivantes : afficher une information sur un écran de contrôle relié au dispositif, afficher une information sur la page d'accueil du compte de l'utilisateur, envoyer un message électronique à l'utilisateur ou à un centre de télésurveillance (email, SMS...), activer un voyant lumineux, déclencher une alarme sonore, etc.

Pour la mise en oeuvre de l'algorithme MA1, il est considéré que la température $TM_{i,j}$ mesurée par chaque magnétomètre $M_i$ de rang i à chaque instant $T_j$ est fonction :

- de la température d'échauffement interne $TSC_{i,j}$ de la puce de semi-conducteur du magnétomètre à l'instant $T_j$, lié à l'activité du magnétomètre,

- de la température ambiante $TA_j$ à l'instant $T_j$ (température de l'air), qui sera considérée comme étant commune à tous les magnétomètres, et

- de la température d'échauffement interne $IHT_{i,j}$ du disjoncteur auquel le magnétomètre $M_i$ est associé.

La température $TM_{i,j}$ est ainsi égale à la somme pondérée de ces trois températures et peut s'écrire ainsi :

$$(1)\ TM_{i,j} + = a_i * TSC_{i,j} + b_i * TA_j + c_i * IHT_{i,j}$$

$a_i$, $b_i$, $c_i$ étant des coefficients de pondération constants avec le temps, représentatifs de l'influence de chaque source de chaleur sur la température $TM_{i,j}$ de la plaquette de semi-conducteur du magnétomètre.

La phase d'analyse S1 telle que mis en oeuvre dans un mode de réalisation de l'invention repose sur une hypothèse simplificatrice concernant la température d'échauffement interne $TSC_{i,j}$ du magnétomètre et sur une évaluation simplificatrice de la température ambiante $TA_j$.

Hypothèse concernant la température $TSC_{i,j}$:

On observe que la température d'échauffement interne $TSC_{i,j}$ de la puce de semi-conducteur du magnétomètre, liée au fonctionnement des circuits internes et aux résistances internes des liaisons silicium, est généralement constante. De plus, leur consommation électrique est très faible et leur échauffement interne, généralement de l'ordre d'un ou deux degrés, peut être considéré comme négligeable devant les sources de chaleur que représentent la température ambiante et l'échauffement du disjoncteur. Ainsi, les variations de la température mesurée $TM_{i,j}$ sont indépendantes de la température d'échauffement interne $TSC_{i,j}$ du semi-conducteur. La température $TSC_{i,j}$ est sans incidence notable sur les variations de la température mesurée $TM_{i,j}$ et l'équation (1) peut se simplifier ainsi, en supprimant la composante $TSC_{i,j}$:

$$(2)\ TM_{i,j}\mathrel{+}= b_i * TA_j + c_i * TD_{i,j}$$

Evaluation de la température ambiante TAj:

Dans un mode de réalisation, la température ambiante $TA_j$ peut être mesurée au moyen d'un capteur de température dédié placé dans le tableau électrique ou à proximité de celui-ci. On observe toutefois que la température ambiante varie très lentement devant la température des disjoncteurs, qui est fonction du courant les traversant et des défaillances pouvant éventuellement se produire. La température ambiante peut donc, sur une courte période de temps, de l'ordre de quelques minutes à quelques centaines de minutes, être considérée comme constante. Ainsi, dans un mode de réalisation de la phase d'analyse S1 ne nécessitant pas de mesurer la température ambiante au moyen d'un capteur dédié, la température ambiante à un instant $T_j$ de rang "j" est estimée à partir des températures $TM_{1,j}$, $TM_{2,j}$, $TM_{3,j}$, $TM_{4,j}$, $TM_{5,j}$, $TM_{6,j}$, $TM_{7,j}$, $TM_8$, mesurées par les magnétomètres.

La température ambiante $TA_j$ peut être estimée selon l'une des méthodes suivantes, dans lesquelles $ETA_j$ est la température ambiante estimée.

Première méthode :

$$(3)\ ETA_j = [TM_{1,j} + TM_{2,j} + TM_{3,j} + TM_{4,j} + TM_{5,j} + TM_{6,j} + TM_{7,j} + TM_{8,j}]/8$$

Dans ce cas, la température ambiante estimée $ETA_j$ est égale à la moyenne des températures mesurées par les magnétomètres $M_i$.

Deuxième méthode :

$$ETA_j = [k1*TM_{1,j} + k2*TM_{2,j} + k3*TM_{3,j} + k4*TM_{4,j} + k5*TM_{5,j} + k6*TM_{6,j} + k7*TM_{7,j} + k8*TM_{8,j}/[k1+k2+k3+k4+k5+k6+k7+k8] \quad (4)$$

Dans ce cas, la température ambiante estimée $ETA_j$ est égale à la moyenne pondérée des températures mesurées par les magnétomètres $M_i$, k1 à k8 étant des coefficients de pondération. On peut par exemple choisir des coefficients de pondération k1 et k8 supérieurs à 1 pour les magnétomètres placés au début et à la fin de la rangée de modules de contrôle, et des coefficients de pondération k2 à k7 égaux à 1 pour les autres modules.

Troisième méthode :

$$(5)\ ETA_j = LOWER\_VALUE\ \{TM_{1,j}, TM_{2,j}, TM_{3,j}, TM_{4,j}, TM_{5,j}, TM_{6,j}, TM_{7,j}, TM_{8,j}\}$$

Dans ce cas, la température ambiante estimée $ETA_j$ est égale à la plus basse valeur ("LOWER_VALUE") de toutes les températures mesurées par les magnétomètres.

Quatrième méthode :

La température ambiante estimée $ETA_j$ peut aussi être calculée par une combinaison des valeurs obtenues selon deux ou trois des méthodes ci-dessus, et être par exemple égale à la valeur moyenne de température obtenue par la formule (3) ou (4) et celle obtenue par la formule (5). D'autres méthodes peuvent être prévues par l'homme du métier, seules ou en combinaison avec l'une des méthodes précédentes, par exemple des méthodes prédictives fondées sur l'observation des températures ambiantes précédentes, la prise en compte de l'heure, du jour et du mois de l'année, des prévisions météorologiques de la journée en cours, etc.

La figure 5 montre un exemple de réalisation de la phase d'analyse S1 et de la phase de décision S2 mettant en oeuvre l'hypothèse et l'évaluation simplificatrices qui viennent d'être décrites. La phase d'analyse comprend des étapes S10, S11, S12 et S13. L'étape S10 notée "REC(TM$_{i,j}$)" sur la figure 5, est une étape de collecte et d'enregistrement ("REC") des températures TM$_{i,j}$ mesurées par les magnétomètres M$_i$ à différents instant T$_j$. Il s'agit d'une tâche de fond qui vise l'enregistrement d'un très grand nombre de températures selon une fenêtre temporelle glissante de référence Tref d'une durée de plusieurs heures, de préférences plusieurs dizaines d'heures, par exemple 24 heures. Si les instants T$_j$ sont séparés d'un intervalle de temps de 3 secondes, le serveur SRV collecte, en 24 heures, pour chaque magnétomètre, 24 * 3600/3 températures TM$_{i,j}$, soit 40 800 températures, à multiplier par le nombre de magnétomètres.

Au cours de l'étape S11, le serveur calcule la température ambiante estimée ETA$_j$ à un instant T$_j$ selon l'une des méthodes décrites plus haut. La méthode montrée sur la figure 5 est celle consistant à retenir la plus basse des températures mesurées par les magnétomètres comme représentative de la température ambiante (formule (5)).

Au cours de l'étape S12, le serveur retranche la température ambiante estimée ETA$_j$ à la valeur de chacune des températures TM$_{i,j}$ mesurées par les magnétomètres au même instant T$_j$, pour l'obtention d'une première estimation IHT1$_{i,j}$ de la température d'échauffement interne de chaque disjoncteur :

$$(6)\ \text{IHT1}_{i,j} = \text{TM}_{i,j} - \text{ETA}_j$$

Ce calcul est effectué pour chaque magnétomètre de rang i, soit ici pour l'obtention de 8 premières estimations IHT1$_{i,j}$. L'étape S12 est répétée pour chaque nouvel instant T$_{j+1}$, en recalculant à chaque fois une nouvelle valeur TA$_{j+1}$ de la température ambiante évaluée, pour obtenir 8 nouvelles estimations IHT1$_{i,j+1}$.

Il sera noté que l'expression "mesurées au même instant" signifie ici "échantillonnées au même instant T$_j$", les températures TM$_{i,j}$ mesurées par les magnétomètres étant échantillonnées à chacun des instants T$_j$ définis par le signal de synchronisation Sync. En pratique, l'instant précis de fourniture des températures TM$_{i,j}$ via le bus de données n'est pas exactement le même, les températures étant reçues les unes après les autres.

L'étape suivante S13 est optionnelle et est fondée sur l'observation selon laquelle les températures TM$_{i,j}$ présentent une erreur variable, ou décalage ("offset"), par rapport à la température réelle des magnétomètres. Ainsi, deux magnétomètres portés à la même température ne mesurent pas nécessairement les mêmes températures. Cet offset peut en pratique atteindre quelques degrés. Pour corriger cette erreur, le serveur, pour chaque magnétomètre M$_i$, calcule la valeur moyenne de toutes les premières estimations IHT$_{i,j}$ calculées en relation avec l'instant T$_j$ et les N instants précédents T$_{j-N}$, T$_{j-(N-1)}$,......, T$_{j-1}$ inclus dans la fenêtre temporelle glissante Tref, soit ($\Sigma$IHT1$_{i,j}$)/N. Le serveur soustrait ensuite cette valeur moyenne à la première estimation IHT$_{i,j}$ pour l'obtention d'une seconde estimation IHT2$_{i,j}$ de la température d'échauffement interne dont la valeur est ainsi la suivante :

$$(7)\ \text{IHT2}_{i,j} = \text{IHT1}_{i,j} - (\textstyle\sum \text{IHT1}_{i,j})/N \text{ avec i constant et } j = j\text{-}N,\ j\text{-}(N\text{-}1),...,\ j\text{-}1,\ j$$

Le nombre N de températures estimées IHT1$_{i,j}$ utilisées pour ce calcul peut être très élevé et est, au maximum, égal au nombre de températures TM$_{i,j}$ ayant été calculées et mémorisées dans la fenêtre temporelle glissante Tref.

La seconde estimation IHT2$_{i,j}$ de la température d'échauffement interne de chaque disjoncteur D$_i$ est ensuite, pour la mise en œuvre de la phase de décision S2, considérée comme formant la température d'échauffement interne IHT$_{i,j}$ du disjoncteur D$_i$, soit :

$$(8)\ \text{IHT}_{i,j} = \text{IHT2}_{i,j}$$

L'étape S13 est, comme l'étape S12, répétée autant de fois qu'il y a de magnétomètres dans le dispositif selon l'invention.

Dans une variante où l'étape S13 n'est pas mise en oeuvre, la première estimation IHT1$_{i,j}$ de la température d'échauffement interne estimée est considérée comme formant la température d'échauffement interne IHT$_{i,j}$ du disjoncteur D$_i$ pour la mise en oeuvre de la phase de décision S2.

Les estimations IHT$_{i,j}$ obtenues au terme de la phase S1 incluant l'étape S13 sont donc affranchies des variations de la température ambiante, et le calcul effectué à l'étape S13 a pour effet de les centrer autour de 0°C. Leur éloignement au-dessus de 0°C est représentatif de l'échauffement interne de chaque disjoncteur, soit sa variation de température par rapport à la température ambiante.

La phase de décision S2 comprend des étapes S20, S21. Au cours de l'étape S20, le serveur détermine si la température d'échauffement interne IHT$_{i,j}$ de chaque disjoncteur D$_i$ est supérieure au seuil de température TT2, qui représente donc une variation de la température du disjoncteur et non sa température réelle. Si la réponse est positive ("Y"), le serveur émet l'alarme A2 pour le disjoncteur concerné, puis réitère l'étape S20 pour le disjoncteur suivant. Si la réponse est négative ("N"), le serveur n'émet pas l'alarme A2 et réitère l'étape S20 pour le disjoncteur suivant. Lorsque les températures d'échauffement interne ont été vérifiées pour chaque disjoncteur, le serveur exécute l'étape S21, sauf dans le cas exceptionnel où chaque disjoncteur aurait une température supérieure à TT2 (non représenté).

Au cours de l'étape S21, le serveur détermine, pour chaque température $IHT_{i,j}$ qui n'a pas été trouvée supérieure au seuil TT2 à l'étape S20, si cette température est supérieure au seuil TT1. Le serveur émet l'alarme A1 pour le disjoncteur concerné si la réponse est positive ("Y"), puis réitère l'étape S21 pour le disjoncteur suivant, sauf si la température du disjoncteur suivant a été trouvée supérieure au seuil TT2 à l'étape S20.

Lorsque toutes les températures d'échauffement interne ont été vérifiées, le serveur retourne à l'étape S10 si les phases S1 et S2 sont exécutées séquentiellement. Toutefois les phases S1 et S2 peuvent aussi être exécutées simultanément, par exemple la phase S1 peut être exécutée en relation avec des températures mesurées à un instant $T_j$ tandis que la phase S2 peut être exécutée en relation avec des températures mesurées à un instant $T_{j-1}$ précédant l'instant $T_j$. Les phases S1 et S2, qu'elles soient simultanées ou séquentielles, peuvent être exécutées dans la période de temps qui sépare deux instants $T_j$, par exemple 3 secondes, ce temps étant très grand à l'échelle du temps de calcul du serveur et largement suffisant pour mettre également à jour les informations sur le profil de l'utilisateur et émettre si nécessaire les alarmes A1, A2. Les phases S1 et S2 peuvent également être exécutées en différé, mais de préférence sans attendre qu'une longue période de temps ne s'écoule, pour des raisons de sécurité de l'installation sous surveillance.

La figure 6 est un schéma bloc d'une variante 50' du dispositif 50 tel que montré sur la figure 3. La structure du dispositif 50' est identique à celle du dispositif 50. Le dispositif 50' se distingue du dispositif 50 en ce que le processeur PRC reçoit des magnétomètres $M_i$, à chacun des instants successifs $T_j$ définis par le signal Sync, en sus des températures $TM_{i,j}$, la valeur échantillonnée $EBx_i$, $EBy_i$, $EBz_i$ d'au moins l'une des composantes de champ magnétique $Bx_i$, $By_i$, $Bz_i$ mesurées par chaque magnétomètre $M_i$. Selon un procédé décrit dans le document EP2637027, le processeur PRC ou le serveur SRV en déduit le courant $I_{i,j}$ qui traverse, à l'instant $T_j$, chaque disjoncteur $D_i$.

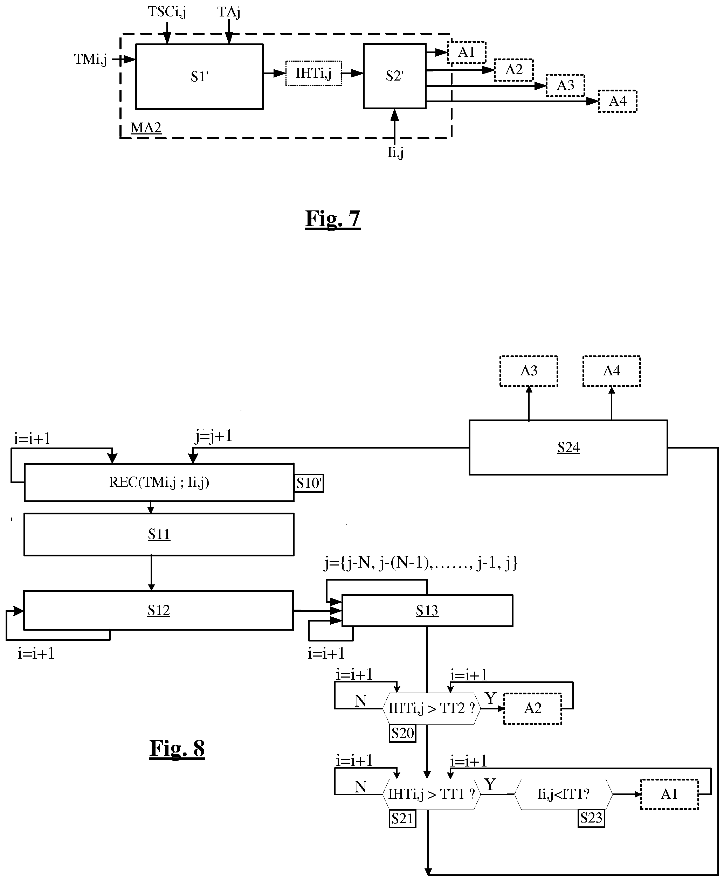

La figure 7 représente un mode de réalisation MA2 de l'algorithme de contrôle selon l'invention mis en oeuvre par le dispositif 50' et prenant en compte la mesure des courants traversant les disjoncteurs. L'algorithme comprend une phase d'analyse S1' et une phase de décision S2'. La phase de décision S2' prend en compte, en sus des températures d'échauffement interne $IHT_{i,j}$ des disjoncteurs, les courants $I_{i,j}$ traversant les disjoncteurs. La phase de décision S2' fournit, en sus des alarmes A1 et A2, une alarme d'un troisième type A3 et une alarme d'un quatrième type A4.

L'alarme A3 est une alarme relative aux taux de fonctionnement des disjoncteurs, qui est fonction du temps pendant lequel un disjoncteur est traversé par un courant, ou périodes de conduction, au cours d'une période d'observation. Cette période d'observation est une fenêtre temporelle glissante de durée Tobs, calée sur chaque instant $T_j$. La fenêtre Tobs est par exemple égale à quelques heures ou à quelques jours selon le type d'équipement alimenté électriquement par le disjoncteur. L'alarme A3 est émise lorsque le taux de fonctionnement d'un disjoncteur augmente de manière très marquée au cours de la période d'observation. L'alarme A4 est émise lorsque le serveur constate une corrélation entre une augmentation notable du taux de fonctionnement et une augmentation de la température du disjoncteur. L'alarme A4 est par exemple émise à la place des alarmes A1 et A3 lorsque les conditions d'émission de l'alarme A1 et de l'alarme A3 sont réunies.

La figure 8 montre un exemple de réalisation de la phase d'analyse S1' et de la phase de décision S2'. La phase d'analyse S1' est identique à la phase S1 précédemment décrite à ceci près que l'étape S10 est remplacée par une phase S10' de collecte et d'enregistrement ("REC"), à chaque instant $T_j$, des températures $TM_{i,j}$ mesurées par les magnétomètres $M_i$ et des courants $I_{i,j}$ estimés à partir des mesures de champ magnétique. Il s'agit comme précédemment d'une tâche de fond qui vise l'enregistrement d'un très grand nombre de températures et de valeurs de courants dans la fenêtre temporelle glissante précitée Tref, par exemple 24 heures. La phase d'analyse comprend par ailleurs les étapes S11, S12 et S13 précédemment décrites, qui sont inchangées.

La phase S2' comprend les étapes S20 et S21 précédemment décrites, et des étapes additionnelles S23 et S24. L'étape S23 est exécutée après l'étape S21, avant d'émettre l'alarme A1, lorsque le résultat de la comparaison avec le seuil de température TT1 est positif. Au cours de l'étape S23, le serveur détermine si le courant $I_{i,j}$ traversant le disjoncteur concerné est inférieur ou non à un seuil de courant IT1. L'alarme A1 n'est émise que si le courant est inférieur à ce seuil IT1. En d'autres termes, on considère ici qu'une température supérieure à TT1 n'est anormale que si le disjoncteur est traversé par un courant pour lequel une telle température ne devrait pas être constatée.

L'étape S24 est une étape de décision et d'analyse de haut niveau visant notamment à émettre les alarmes A3 et A4, et peut être mise en oeuvre au moyen d'algorithmes complexes pouvant faire appel à des méthodes d'intelligence artificielle. L'étape S24 vise à faire la corrélation entre le taux de fonctionnement des disjoncteurs, les températures d'échauffement interne des disjoncteurs et les courants observés dans les disjoncteurs. Un histogramme des périodes de conduction de chaque disjoncteur peut également être pris en compte, avant de prendre la décision d'émettre l'alarme A3 et/ou A4.

Notamment, dans un mode de réalisation, lorsque les températures d'échauffement interne de deux disjoncteurs contigus $D_i$, $D_{i+1}$ atteignent chacune le premier seuil de température TT1, le serveur peut décider de ne pas émettre l'alarme A1 pour le disjoncteur $D_i$ si celui-ci n'a été traversé par aucun courant pendant un temps déterminé.

Pour l'émission de l'alarme A3, le serveur peut par exemple calculer le taux de fonctionnement de chaque disjoncteur dans la période d'observation Tobs, en tenant compte du nombre de périodes de conduction et de la durée de chacune de ces périodes, et surveiller la variation du taux de fonctionnement du disjoncteur à l'intérieur de la période d'observation. L'alarme A3 est émise si la variation du taux de fonctionnement du disjoncteur considéré dépasse un seuil de variation TXF déterminé. L'émission de l'alarme A3 est par exemple assujettie à une analyse de l'histogramme du taux de fonctionnement du disjoncteur, à savoir la fréquence et la durée des périodes de conduction du disjoncteur dans la période d'observation Tobs. Le serveur classe par exemple les périodes de conduction dans des classes de durées différentes, par exemple 10 minutes, 1 heure, 3 heures et 24 heures. Une anomalie justifiant l'émission de l'alarme A3 est constatée lorsque l'histogramme montre une forte variation de la classification des périodes de conduction dans ces diverses classes, accompagnée d'une augmentation globale du taux de fonctionnement sur la période d'observation. Par exemple un équipement tel un système frigorifique, qui présente normalement des cycles de fonctionnement de 30 minutes, correspondant à un passage de courant dans le disjoncteur, entrecoupés de cycles d'arrêt de 15 minutes, sera considéré comme potentiellement en défaut s'il présente soudainement, par exemple sur les dernières 24 heures, des cycles de fonctionnement de 2 heures entrecoupés de cycles d'arrêt de 5 minutes. Si simultanément les conditions sont réunies pour l'émission de l'alarme A1, l'alarme A4, signifiant ici que deux anomalies se produisent en même temps, sera émise à la place des alarmes A1 et A3.

Il peut par ailleurs se produire que l'accroissement de la température d'un disjoncteur $D_i$ ne soit pas dû au courant le traversant ou à un défaut de fonctionnement, mais à l'échauffement d'un disjoncteur contigu, par exemple le disjoncteur $D_{i+1}$, qui se communique au disjoncteur $D_i$ par conductivité thermique. Ainsi, ce qui a été considéré jusqu'à présent comme la "température d'échauffement interne" d'un disjoncteur ne constitue qu'une température d'échauffement interne supposée, à savoir une température qui est supposée être liée à un échauffement interne du disjoncteur. En réalité cette température peut être due, en tout ou en partie, à celle d'un disjoncteur contigu. Pour des raisons de simplification du langage, le terme "température d'échauffement interne" d'un disjoncteur est toutefois conservé dans toute la description et les revendications comme représentatif d'un échauffement du disjoncteur indépendant de la température ambiante et causé par l'état de fonctionnement du disjoncteur incluant éventuellement l'état de fonctionnement de disjoncteurs voisins.

Lorsque l'accroissement de la température d'échauffement interne d'un disjoncteur $D_i$ est dû en tout ou en partie à l'échauffement d'un disjoncteur contigu, l'émission de l'alarme A1 pour ce disjoncteur peut être inhibée par le serveur. Ainsi, lorsque les conditions d'émission de l'alarme A1 sont réunies pour deux disjoncteurs contigus, le serveur compare les taux de fonctionnement de chaque disjoncteur pour identifier le disjoncteur ayant la plus forte probabilité d'anomalie de son état de fonctionnement, et n'émet l'alarme A1 que pour le disjoncteur ayant la plus forte probabilité d'anomalie de son état de fonctionnement.

Il apparaîtra clairement à l'homme de l'art que l'algorithme qui vient d'être décrit est susceptible de diverses variantes et modes de réalisation. Notamment, bien que l'on ait proposé dans ce qui précède d'estimer des températures d'échauffement interne $IHT_{i,j}$ incluant un recentrage de ces températures autour de zéro (étape S13), la phase S1 peut être conçue pour ne calculer et ne fournir que les variations relatives des températures d'échauffement interne des disjoncteurs, sans recentrage. La phase S2 peut aussi être basée sur l'analyse de ces variations au moyen d'un algorithme classifieur à intelligence artificielle, incluant éventuellement une phase d'apprentissage et/ou une phase d'étalonnage des températures à la mise en service de disjoncteurs.

Également, dans une variante de réalisation du procédé qui vient d'être décrit, l'étape S12 est supprimée. Le serveur ne calcule pas une estimation de la température d'échauffement interne $IHT_{i,j}$ des disjoncteurs au cours de la phase S1 et peut seulement, de manière optionnelle, recentrer les valeurs des températures $TM_{i,j}$ mesurées par les magnétomètres en les divisant par leur valeur moyenne calculée sur N instants $T_j$, en appliquant l'étape S13 aux températures $TM_{i,j}$ au lieu de l'appliquer aux estimations $IHT_{i,j}$. Dans ce cas, au cours des étapes S20 et S21 de la phase S2, le serveur compare les températures $TM_{i,j}$ à des seuils de température variables $TT1_j$ et $TT2_j$ qui sont corrigés à chaque instant $T_j$ en fonction de la température ambiante courante $TA_j$, par exemple de la façon suivante :

$$(9)\ TT1_j = TT1 + TA_j$$

$$(10)\ TT2_j = TT2 + TA_j$$

Il sera observé que cette variante est, sur le fond, équivalente au mode de réalisation précédemment décrit, dans la mesure où les tests des étapes S20, S21, soit :

$$(11)\ IHT_{i,j} > TT1$$

$$(12)\ \mathrm{IHT}_{i,j} > TT2$$

peuvent aussi s'écrire :

$$(13)\ \mathrm{IHT}_{i,j} =\ \mathrm{TM}_{i,j} - \mathrm{TA}_j > TT1$$

$$(14)\ \mathrm{IHT}_{i,j} =\ \mathrm{TM}_{i,j} - \mathrm{TA}_j > TT2$$

soit :

$$(15)\ \mathrm{TM}_{i,j} > TT1 + \mathrm{TA}_j$$

$$(16)\ \mathrm{TM}_{i,j} > TT2 + \mathrm{TA}_j$$

En d'autres termes, pour déterminer, à partir des températures $\mathrm{TM}_{i,j}$ mesurées par les magnétomètres et de la température ambiante, si la température d'échauffement interne $\mathrm{IHT}_{i,j}$ d'un disjoncteur atteint un seuil de température, il est également possible de comparer les températures $\mathrm{TM}_{i,j}$ mesurées par les magnétomètres à un seuil qui est modulé en fonction de la température ambiante $\mathrm{TA}_j$.

Il apparaîtra également à l'homme de l'art que le procédé d'analyse du fonctionnement des disjoncteurs qui vient d'être décrit peut être mise en oeuvre sans mesure de courant, en remplaçant les magnétomètres par des capteurs de courant intégrés sur microplaquettes de semi-conducteur.

On rappellera maintenant les caractéristiques générales du procédé décrit par le document EP2637027, permettant de mesurer le courant traversant un disjoncteur $D_i$ au moyen du magnétomètre triaxial $M_i$ qui lui est associé.

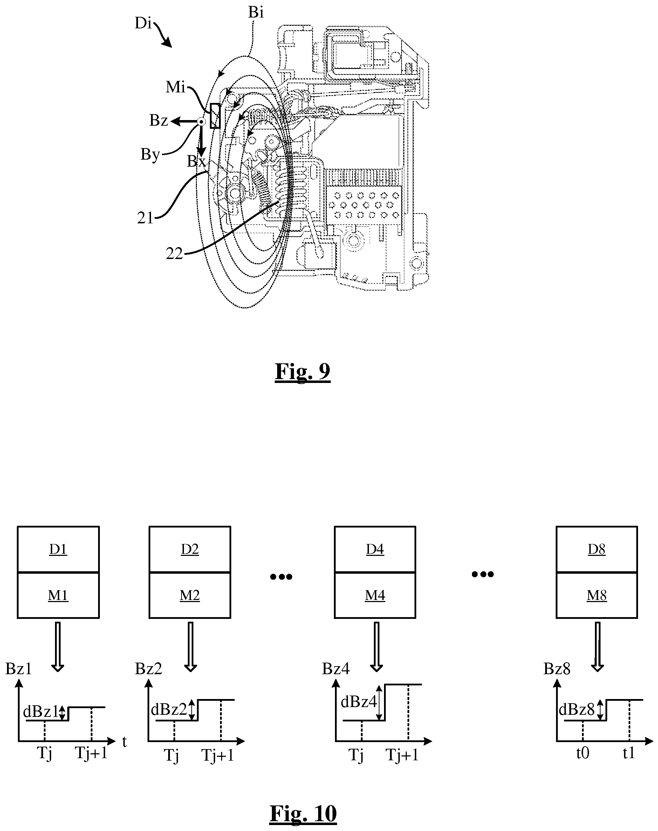

La figure 9 est une vue en coupe d'un disjoncteur $D_i$. On aperçoit le levier de réarmement 21 et la bobine de protection 22 du disjoncteur, ainsi que le magnétomètre $M_i$ fixé sur une face du disjoncteur. Les trois composantes Bx, By, Bz du champ magnétique émis par la bobine de protection, mesurables au moyen du magnétomètre $M_i$, sont également représentées.

Comme montré sur la figure 6, le processeur PRC fournit le signal de synchronisation Sync et reçoit, en sus de la température $\mathrm{TM}_{i,j}$, au moins l'une des composantes échantillonnées $\mathrm{EBx}_i$, $\mathrm{EBy}_i$, $\mathrm{EBz}_i$ du champ magnétique émis par chaque disjoncteur, telles que mesurées par le magnétomètre triaxial $M_i$ qui lui est associé.

La composante reçue et prise en compte pour mesurer les courants traversant les disjoncteurs est celle qui, selon la structure des disjoncteurs, est la plus représentative de ces courants. Le processeur PRC peut également recevoir et traiter les échantillons $\mathrm{EBx}_i$, $\mathrm{EBy}_i$ des composantes $\mathrm{Bx}_i$, $\mathrm{By}_i$, si une plus grande précision de mesure est visée.

Les étapes qui suivent sont décrites comme étant réalisés par le processeur PRC mais pourraient également être exécutées par le serveur, ce dernier recevant alors tout ou partie des échantillons $\mathrm{EBx}_i$, $\mathrm{EBy}_i$, $\mathrm{EBz}_i$ des composantes $\mathrm{Bx}_i$, $\mathrm{By}_i$, $\mathrm{Bz}_i$.

Le processeur PRC (ou le serveur) applique une étape de traitement aux échantillons $\mathrm{EBz}_i$, ou aux échantillons $\mathrm{EBx}_i$, $\mathrm{EBy}_i$, $\mathrm{EBz}_i$, pour supprimer une composante continue due au champ magnétique terrestre et calculer leur valeur efficace. La suppression de la composante continue est faite en calculant la valeur moyenne de tous les échantillons sur N échantillons, et en soustrayant cette valeur moyenne de la valeur de chaque échantillon. La valeur efficace des composantes, ou valeur RMS, est ensuite déterminée par le processeur PRC en calculant la racine carrée de la somme des échantillons au carré divisée par le nombre N1 d'échantillons, suivant la formule classique $\sqrt{[(1/N1)(\Sigma EBzi)]}$. Des algorithmes simplificateurs en soi connus peuvent être utilisés pour effectuer ce calcul de valeur efficace en économisant des ressources de calcul ou de la mémoire.

Dans ce qui suit, on désignera par "$\mathrm{Bx}_i$", "$\mathrm{By}_i$", "$\mathrm{Bz}_i$" les valeurs efficaces des composantes portant la même référence, calculées comme cela vient d'être indiqué. Par "composante", on entendra cette valeur efficace, calculée à un instant donné à partir de plusieurs échantillons. Cette valeur efficace est recalculée régulièrement, pour obtenir plusieurs valeurs de la composante et suivre son évolution dans le temps pour la mise en oeuvre des étapes décrites ci-après.

Le processeur PRC applique à la composante $\mathrm{Bz}_i$ ainsi calculée, ou aux composantes $\mathrm{Bx}_i$, $\mathrm{By}_i$, $\mathrm{Bz}_i$ ainsi calculées, une étape de traitement visant à neutraliser les effets d'un phénomène d'interférence magnétique entre disjoncteurs. Cette étape de traitement permet d'obtenir des composantes corrigées $CBz_i$, ou des groupes de composantes corrigées $CBx_i$, $CBy_i$, $CBz_i$.

Le processeur PRC est également configuré pour transformer chaque composante corrigée $CBz_i$, ou chaque groupe de composantes corrigées $CBx_i$, $CBy_i$, $CBz_i$, en une valeur de courant circulant dans le disjoncteur $D_i$ associé au magnétomètre considéré $M_i$, soit la valeur du courant qui circule dans la branche du réseau électrique que le disjoncteur protège.

La transformation d'une composante corrigée $CBz_i$ en une valeur de courant est assurée au moyen de paramètres de conversion mémorisés par le processeur PRC, déterminés pendant une phase d'étalonnage. Cette phase d'étalonnage comprend par exemple, pour chaque disjoncteur :

- une étape d'ouverture de tous les disjoncteurs sauf celui devant être étalonné, qui est laissé dans l'état passant,

- une étape de mesure du courant dans la ligne électrique protégée par le disjoncteur; par tout moyen classique, ou d'estimation de ce courant en connectant la ligne à une charge électrique dont la consommation est connue,

- une étape de mesure de la composante $Bz_i$ du champ magnétique correspondant, au moyen du magnétomètre correspondant $M_i$, et

- une étape de mémorisation du courant I mesuré et de la composante $Bz_i$, ou du rapport $I/Bz_i$ entre le courant mesuré et la composante $Bz_i$.

Ces étapes d'étalonnage peuvent être répétées avec plusieurs valeurs de courant, pour plus de précision. Si le processeur PRC exploite les deux composantes $Bx_i$, $By_i$ pour mesurer le courant, une étape d'étalonnage similaire est appliquée à celles-ci. Le processeur PRC obtient ensuite trois valeurs de courant à partir de chaque composante, et fait la moyenne de ces valeurs pour déterminer la valeur du courant, ou calcule le module du vecteur champ magnétique associé à ces trois composantes pour en déduire la valeur du courant.

La neutralisation de l'effet d'interférence magnétique, si elle s'avère nécessaire, peut être effectuée comme suit. Dans un souci de simplicité, on ne considérera que la suppression des interférences dans la composante $Bz_i$, ce qui suit étant applicable aux deux autres composantes.

Comme illustré schématiquement sur la figure 10, considérons à titre d'exemple la rangée de disjoncteurs $D_i$ (D1 à D8) du dispositif 50, chacun étant équipé d'un magnétomètre $M_i$ (M1 à M8). Chaque disjoncteur $D_i$ crée un champ magnétique qui est régit par la loi de Biot et Savard et s'étend sur une certaine distance, avec une décroissance en 1/d dans les 3 directions de détection, "d" étant la distance relativement à la bobine du disjoncteur. A un instant donné $T_j$, sur réception du signal de synchronisation Sync envoyé par le processeur PRC, chaque magnétomètre $M_i$ fournit la composante $Bz_i$ du champ magnétique émis par le disjoncteur correspondant $D_i$. Cette composante $Bz_i$ est entachée d'une erreur causée par l'addition des champs magnétiques émis par les disjoncteurs voisins, s'ils sont traversés par du courant, et n'est donc plus proportionnelle au seul courant qui passe dans le disjoncteur $D_i$.

L'homme de l'art peut définir des méthodes ou des algorithmes permettant de soustraire à la composante $Bz_i$ les effets de l'interférence. Une méthode consiste par exemple en un étalonnage avant la mise en service du dispositif : pour chaque disjoncteur $D_i$, on mesure systématiquement, pour toute une gamme de valeurs de courants, l'interférence produit par le disjoncteur $D_i$ sur tous les disjoncteurs voisins. On forme ainsi une base de données qui est fournie au processeur PRC et utilisée par ce dernier pour corriger les composantes $Bz_i$ fournies par les magnétomètres $M_i$.

Optionnellement, le processeur PRC exécute un procédé de suppression d'interférence par apprentissage, ne nécessitant pas d'étalonnage. Ce procédé comprend une phase d'apprentissage et une phase d'exploitation.

Phase d'apprentissage :

i) le processeur PRC mesure les composantes $Bz_i$ (Bz1 à Bz8) à deux instants $T_j$ et $T_{j+1}$, et calcule la variation $dBz_i = Bz_i(T_{j+1}) - Bz_i(T_j)$ de chaque composante $Bz_i$.

ii) le processeur PRC recherche la plus forte variation $dBz_i$ en valeur absolue. Il s'agit par exemple de dBz4 dans l'exemple montré sur la figure 10.

iii) le processeur PRC attribue l'origine de la variation de chaque composant $Bz_i$ à une variation de courant dans le disjoncteur qui présente la plus forte variation de son champ magnétique, ici le disjoncteur D4, et suppose donc que le courant n'a pas varié dans les autres disjoncteurs (cette étape est implicite et sous-tend l'étape iv ci-après).

iv) le processeur PRC calcule, pour le disjoncteur D4, un paramètre d'interférence $P_{i,4}$ qui représente l'influence du disjoncteur D4 sur les magnétomètres $M_i$ associés aux autres disjoncteurs, avec :

$$Pi,4 \ = \ dBzi/dBz4$$

Pour le magnétomètre M4, ce paramètre est donc égal à 1.

v) le processeur PRC réitère les étapes i à iv au fur et à mesure des variations de courant dans les divers disjoncteurs, jusqu'à obtenir un paramètre d'interférence $P_{i,j}$ de chaque disjoncteur de rang j sur chaque magnétomètre de rang i, soit :

$$Pi,j \ = \ dBzi/dBzj$$

pour i allant ici de 1 à 8 et j allant de 1 à 8. Chaque calcul est comme précédemment basé sur la détection de la plus grande variation mesurée dBz en valeur absolue. Chaque paramètre d'interférence $P_{i,j}$ peut être calculé plusieurs fois et ensuite moyenné, pour obtenir une valeur plus précise.

vi) Au terme de l'étape d'apprentissage, le processeur PRC obtient un ensemble de vecteurs d'interférence $VINT_j$. Chaque vecteur d'interférence $VINT_j$ est associé à un disjoncteur $D_i$ et comprend les paramètres d'interférence de ce disjoncteur sur les magnétomètres associés aux autres disjoncteurs. Par exemple, pour le disjoncteur D4, le vecteur d'interférence VINT4 est égal à :

$$VINT4 \ = \ \{dBz1/dBz4, dBz2/dBz4, dBz3/dBz4, 1, dBz5/dBz4, dBz6/dBz4, dBz7 \\ /dBz4, dBz8/dBz4\}$$

Soit :

$$VINT4 \ = \ \{P1,4, P2,4, P3,4, 1, P5,4, P6,4, P7,4, P8,4\}$$

Le processeur PRC définit ensuite une matrice d'interférence "MINT" montrée ci-après, en associant à chaque colonne de la matrice un vecteur d'interférence $VINT_j$. Le vecteur VINT1 forme la première colonne de la matrice, le vecteur VINT2 la deuxième colonne, etc.

Matrice MINT

[Tableau 2]

| 1 | dBz1/dBz2 | dBz1/dBz3 | dBz1/dBz4 | dBz1/dBz5 | dBz1/dBz6 | dBz1/dBz7 | dBz1/dBz8 |
|---|---|---|---|---|---|---|---|
| dBz2/dBz1 | 1 | dBz2/dBz3 | dBz2/dBz4 | dBz2/dBz5 | dBz2/dBz6 | dBz2/dBz7 | dBz2/dBz8 |
| dBz3/dBz1 | dBz3/dBz2 | 1 | dBz3/dBz4 | dBz3/dBz5 | dBz3/dBz6 | dBz3/dBz7 | dBz3/dBz8 |
| dBz4/dBz1 | dBz4/dBz2 | dBz4/dBz3 | 1 | dBz4/dBz5 | dBz4/dBz6 | dBz4/dBz7 | dBz4/dBz8 |
| dBzS/dBz1 | dBzS/dBz2 | dBz5/dBz3 | dBz5/dBz4 | 1 | dBz5/dBz6 | dBz5/dBz7 | dBz5/dBz8 |
| dBz6/dBz1 | dBz6/dBz2 | dBz6/dBz3 | dBz6/dBz4 | dBz6/dBz5 | 1 | dBz6/dBz7 | dBz6/dBz8 |
| dBz7/dBz1 | dBz7/dBz2 | dBz7/dBz3 | dBz7/dBz4 | dBz7/dBz5 | dBz7/dBz6 | 1 | dBz7/dBz8 |
| dBz8/dBz1 | dBz8/dBz2 | dBz8/dBz3 | dBz8/dBz4 | dBz8/dBz5 | dBz8/dBz6 | dBz8/dBz7 | 1 |

La matrice MINT obtenue au cours de la phase d'apprentissage peut être imparfaite. L'apprentissage peut donc se poursuivre pendant la phase d'exploitation, pour affiner les paramètres d'interférence. Ainsi, la phase d'apprentissage peut être superposée à la phase d'exploitation. Un critère d'arrêt de la phase d'apprentissage peut être prévu, par exemple lorsque chacun des paramètres d'interférence calculés se stabilise au voisinage d'une valeur moyenne.

Phase d'exploitation :

La phase d'exploitation repose sur le raisonnement suivant :

1) Soit M un vecteur des mesures magnétiques vraies, c'est-à-dire entachées d'interférences, comprenant l'ensemble des composantes $Bz_i$ :

$$M = \{Bz1, Bz2, Bz3, Bz4, Bz5, Bz6, Bz7, Bz8\}$$

2) Soit S un vecteur de mesures magnétiques sans interférence, comprenant des composantes $CBz_i$ qui seraient mesurées s'il n'y avait pas d'interférence :

$$S = \{CBz1, CBz2, CBz3, CBz4, CBz5, CBz6, CBz7, CBz8\}$$

On peut écrire :

$$M = MINT \; x \; S$$

A cet effet, on suppose que la matrice MINT ne dépend que de la topologie des disjoncteurs et non pas des courants qui y circulent. L'homme de l'art reconnaîtra dans cette hypothèse le fait que les champs ne sont pas couplés d'un disjoncteur à l'autre. Cette hypothèse a été vérifiée par des mesures en laboratoire.

En d'autres termes, le vecteur des mesures magnétiques vraies M, est égal au produit du vecteur des mesures magnétiques sans interférence S par la matrice d'interférence MINT. Cela signifie que chaque composante $Bz_i$ mesurée sur un disjoncteur $D_i$ est égale à la composante sans interférence $CBz_i$ du disjoncteur à laquelle on ajoute la somme des interférences, soit la somme des produits de chaque paramètre d'interférence $dBz_i/dBz_j$ par les valeurs de la composante correspondante sans interférence $CBz_j$ mesurée sur un autre disjoncteur, soit par exemple :

$$\begin{aligned} Bz1 = CBz1 &+ CBz2 * dBz1/dBz2 + CBz3 * dBz1/dBz3 + CBz4 * dBz1/dBz4 \\ &+ CBz5 * dBz1/dBz5 + CBz6 * dBz1/dBz6 + CBz7 * dBz1/dBz7 \\ &+ CBz8 * dBz1/dBz8 \end{aligned}$$

Il est donc possible d'écrire :

$$S = MINT^{-1} \; x \; M$$

$MINT^{-1}$ étant la matrice inversée du vecteur M.

Ainsi, au cours de la phase d'exploitation, le processeur PRC calcule la matrice inversée $MINT^{-1}$ et l'utilise pour transformer le vecteur de mesures magnétiques vraies M en vecteur de mesures magnétiques sans interférence S. Le calcul du vecteur S fournit au processeur PRC les valeurs corrigées $CBz_i$ des composantes mesurées $Bz_i$, à partir desquelles il en déduit la valeur du courant traversant chaque disjoncteur.

La matrice MINT pouvant être mal conditionnée, son inversion peut être calculée en faisant appel à des méthodes telles que la méthode des pseudo-inverses, ou encore des méthodes de type SVD ("Singular Value Décomposition" ou "décomposition par valeur singulière") qui permettent d'obtenir une valeur exacte ou approchée de la matrice inverse $MINT^{-1}$. On entend par "mal conditionnée" le fait que la matrice peut être entachée d'incertitudes de mesures. Dans ce cas, le calcul de la matrice inverse peut faire apparaître des rapports de valeurs très faibles produisant des valeurs aléatoires. La méthode SVD, par exemple, consiste à mettre les valeurs faibles à 0 et à former une matrice pseudo-inverse qui prend en compte les valeurs nulles, cette méthode étant bien connue de l'homme de l'art.

Également il apparaîtra clairement à l'homme de l'art que le calcul du vecteur S effectué au moyen de la matrice inverse $MINT^{-1}$ est susceptible d'être effectué suivant diverses autres méthodes mathématiques ou algorithmes de calcul, la matrice n'étant qu'un simple outil mathématique. Par exemple une méthode utilisant des algorithmes neuronaux pourrait être mise en oeuvre.

Ce calcul permet de soustraire de chaque composante mesurée $Bz_i$ la somme des produits des autres com-

posantes $Bz_i$ par leurs paramètres d'interférence respectifs, pour obtenir la composante corrigée $CBz_i$. En effet, si l'on désigne par $C_{i,j}$ les termes de la matrice inverse, on peut écrire que :

$$CBzi = \Sigma(j = 1 \to N2) \, x \, Ci, j * Bzj$$

avec j allant de 1 à N2, N2 étant le nombre de disjoncteurs, et i le rang du disjoncteur considéré.

Ainsi, les composantes corrigées $CBz_i$ s'obtiennent chacune comme une combinaison linéaire des composantes mesurées $Bz_j$, pour j variant de 1 à N2. Les coefficients de ces combinaisons linéaires sont généralement négatifs pour les champs qui présentent toujours la même orientation, sauf à concevoir le cas où les courants seraient déphasés de 180° d'un disjoncteur à l'autre sous l'effet d'une charge capacitive pure, ce qui apparaît comme étant impossible en pratique.

Le procédé qui vient d'être décrit peut optionnellement être également appliqué aux composantes $Bx_i$, $By_i$, pour une mesure de champ plus précise, notamment dans des applications où les disjoncteurs présentent une composante $Bz_i$ qui n'est pas nettement supérieure aux composantes $Bx_i$ et $By_i$. De même, s'il advient que certains modèles de disjoncteurs présentent une composante $Bx_i$ ou $By_i$ supérieure aux deux autres, cette composante peut être utilisée préférentiellement à la place de la composante $Bz_i$, s'il n'est pas souhaité d'utiliser les trois composantes. Deux composantes sur trois pourraient également être utilisées, au lieu d'une seule ou des trois à la fois.

Il apparaîtra clairement à l'homme de l'art que la présente invention est susceptible de diverses autres variantes et modes de réalisation. Notamment, il n'est pas exclu qu'il puisse exister sur le marché des modèles de disjoncteurs ayant un point de concentration du champ magnétique situé en un autre point qu'à proximité du levier de réarmement, par exemple sur une autre paroi du disjoncteur. Dans ce cas, des modules selon l'invention pourraient avoir une autre forme que celle montrée sur les dessins.

Dans un mode de réalisation d'un module selon l'invention, un blindage magnétique est réalisé autour de chaque magnétomètre, au moyen d'un métal présentant de préférence une bonne perméabilité magnétique. Le blindage entoure le magnétomètre $M_i$ et laisse donc passer la composante $Bz_i$ perpendiculaire au socle 31 (figure 1) du module 30-i, qui est émise par le disjoncteur sur lequel le module 30-1 est agencé (figure 2), tout en bloquant les composantes $Bx_i$ et $By_i$ émises par les autres disjoncteurs (figure 9), qui se propagent parallèlement au socle 31. Dans ce cas, le phénomène d'interférence est fortement atténué grâce au blindage que chaque module comporte. Il peut alors n'être plus nécessaire de calculer des composantes corrigées $CBz_i$, les composantes $Bz_i$ pouvant être exploitées par le processeur PRC sans correction après suppression de la composante continue du champ magnétique terrestre. La prévision du blindage magnétique peut aussi être combinée à la correction des composantes $Bz_i$, pour une mesure encore plus précise.

## Revendications

1. Procédé pour contrôler l'état de fonctionnement d'un ensemble de disjoncteurs ($D_i$, D1-D8), chaque disjoncteur comprenant une bobine de protection (22) et présentant une paroi traversée par un champ magnétique ($Bx_i$, $By_i$, $Bz_i$) émis par la bobine, le procédé comprenant les étapes consistant à :

   - agencer sur la paroi de chaque disjoncteur un magnétomètre numérique triaxial synchrone (Mi) sur microplaquette de semi-conducteur, chaque magnétomètre comprenant des moyens de mesure de champ magnétique et un capteur de température interne, et une sortie de données pour fournir des mesures de champ magnétique et de température,

   procédé **caractérisé en ce qu'**il comprend les étapes consistant à :

   - lire cycliquement et de manière synchrone, à des instants successifs ($T_j$), les températures ($TM_{i,j}$) fournies par les magnétomètres,
   - à partir des températures ($TM_{i,j}$) mesurées par les magnétomètres et d'une valeur de la température ambiante ($ETA_j$), déterminer, pour chaque disjoncteur, si une température d'échauffement interne ($IHT_{i,j}$) du disjoncteur atteint un premier seuil de température (TT1) pouvant être représentatif d'une anomalie de l'état de fonctionnement du disjoncteur, et
   - émettre une alarme d'un premier type (A1) lorsque la température d'échauffement interne ($IHT_{i,j}$) d'au moins un disjoncteur atteint le premier seuil de température (TT1).

2. Procédé selon la revendication 1, dans lequel la valeur de la température ambiante ($ETA_j$) est estimée à partir des températures ($TM_{i,j}$) mesurées par les magnétomètres.

3. Procédé selon la revendication 2, dans lequel la valeur de la température ambiante ($ETA_j$) est choisie parmi l'une des valeurs suivantes :

   - une valeur moyenne des températures ($TM_{i,j}$) mesurées au même instant ($T_j$) par les magnétomètres,
   - une valeur moyenne pondérée des températures ($TM_{i,j}$) mesurées au même instant ($T_j$) par les magnétomètres,
   - la plus basse des températures ($TM_{i,j}$) mesurées au même instant ($T_j$) par les magnétomètres, ou
   - une combinaison d'au moins deux des trois valeurs précédentes.

4. Procédé selon l'une des revendications 1 à 3, comprenant au moins la première des deux étapes suivantes :

   - pour chaque magnétomètre et disjoncteur associé au magnétomètre, soustraire la valeur de température ambiante ($ETA_j$) à chaque température ($TM_{i,j}$) mesurée par le magnétomètre, pour l'obtention d'une première estimation ($IHT1_{i,j}$) de la température d'échauffement interne du disjoncteur, et
   - pour chaque magnétomètre et disjoncteur associé au magnétomètre, soustraire à chaque première estimation ($IHT1_{i,j}$) de la température d'échauffement interne du disjoncteur, la valeur moyenne d'une pluralité d'estimations ($IHT1_{i,j}$) de la température d'échauffement interne du disjoncteur calculées à des instants différents ($T_j$), pour l'obtention d'une seconde estimation ($IHT2_{i,j}$) de la température d'échauffement interne du disjoncteur.

5. Procédé selon l'une des revendications 1 à 4, comprenant les étapes consistant à :

   - déterminer, pour chaque disjoncteur, si la température d'échauffement interne ($IHT_{i,j}$) du disjoncteur atteint un second seuil de température (TT1), et
   - émettre une alarme d'un deuxième type (A2) si la température d'échauffement interne ($IHT_{i,j}$) atteint un second seuil de température (TT2) supérieur au premier seuil de température (TT1).

6. Procédé selon l'une des revendications 1 à 5 comprenant les étapes consistant à :

   - lire cycliquement et de manière synchrone, à des instants successifs ($T_j$), les valeurs d'au moins une composante ($Bz_i$) du champ magnétique mesurée par chaque magnétomètre, représentative du champ émis par la bobine du disjoncteur auquel chaque disjoncteur est associé, et
   - évaluer la valeur d'un courant ($I_{i,j}$) traversant chaque disjoncteur à partir de la composante du champ magnétique mesurée.

7. Procédé selon la revendication 6, dans lequel l'alarme du premier type (A1) n'est émise que si le disjoncteur est traversé par un courant inférieur à un seuil de courant (IT1) pour lequel sa température d'échauffement interne ne devrait pas dépasser le premier seuil de température (TT1).

8. Procédé selon l'une des revendications 6 et 7, comprenant, dans lequel lorsque les températures d'échauffement interne ($IHT_{i,j}$) de deux disjoncteurs contigus atteignent chacune le premier seuil de température (TT1), l'alarme du premier type (A1) n'est pas émise pour celui des deux disjoncteurs qui n'a été traversé par aucun courant pendant un temps déterminé.

9. Procédé selon l'une des revendications 6 à 8, comprenant les étapes suivantes, pour chaque disjoncteur :

   - évaluer de manière cyclique le courant ($I_{i,j}$) traversant le disjoncteur,
   - évaluer, dans une fenêtre temporelle d'observation d'une durée de quelques heures à quelques jours, un taux de fonctionnement du disjoncteur qui est fonction du nombre de périodes où le disjoncteur est traversé par un courant, et de la durée de chacune de ces périodes,
   - surveiller la variation du taux de fonctionnement du disjoncteur à l'intérieur de la fenêtre temporelle d'observation, et
   - émettre une alarme d'un troisième type (A3) indiquant une possibilité de dysfonctionnement d'un équipement alimenté électriquement par le disjoncteur si la variation du taux de fonctionnement du disjoncteur dépasse un seuil de variation déterminé.

10. Procédé selon la revendication 9, comprenant, lorsque les conditions d'émission de l'alarme du premier type (A1) sont réunies pour deux disjoncteurs contigus, une étape consistant à comparer les taux de fonctionnement de chaque disjoncteur pour identifier le disjoncteur ayant la plus forte probabilité d'anomalie de son état de fonctionnement, l'élévation de la température de l'un des disjoncteurs pouvant être causée par l'élévation de la température de l'autre disjoncteur, et dans lequel l'alarme du premier type (A1) n'est émise que pour le disjoncteur ayant la plus forte probabilité d'anomalie de son état de fonctionnement.

11. Dispositif pour contrôler l'état de fonctionnement d'un ensemble de disjoncteurs, chaque disjoncteur ($D_i$) comprenant une bobine de protection (22) et présentant une paroi traversée par un champ magnétique ($Bx_i$, $By_i$, $Bz_i$) émis par la bobine, le dispositif comprenant :

- un ensemble de magnétomètres numériques triaxiaux synchrones (Mi) sur microplaquettes de semi-conducteur, chaque magnétomètre étant agencé sur la paroi d'un disjoncteur et comprenant des moyens de mesure de champ magnétique, un capteur de température interne et une sortie de données pour fournir des mesures de champ magnétique et de température, et
- un circuit de contrôle (MCT, SRV) relié aux magnétomètres,

**caractérisé en ce que** le circuit de contrôle (MCT, SRV) est configuré pour :

- lire cycliquement et de manière synchrone, à des instants successifs ($T_j$), les températures ($TM_{i,j}$) mesurées par les magnétomètres,
- à partir des températures ($TM_{i,j}$) mesurées par les magnétomètres et d'une valeur de la température ambiante ($ETA_j$), déterminer, pour chaque disjoncteur, si une température d'échauffement interne ($IHT_{i,j}$) du disjoncteur atteint un premier seuil de température (TT1) pouvant être représentatif d'une anomalie de l'état de fonctionnement du disjoncteur, et
- émettre une alarme d'un premier type (A1) lorsque la température d'échauffement interne ($IHT_{i,j}$) d'au moins un disjoncteur atteint le premier seuil de température (TT1).

12. Dispositif selon la revendication 11, dans lequel le circuit de contrôle est configuré pour estimer la valeur de la température ambiante ($ETA_j$) à partir des températures ($TM_{i,j}$) mesurées par les magnétomètres.

13. Dispositif selon l'une des revendications 11 et 12, dans lequel le circuit de contrôle est configuré pour exécuter au moins la première des deux étapes suivantes, pour chaque magnétomètre et disjoncteur associé au magnétomètre :

- soustraire la valeur de température ambiante ($ETA_j$) à chaque température ($TM_{i,j}$) mesurée par le magnétomètre, pour l'obtention d'une première estimation ($IHT1_{i,j}$) de la température d'échauffement interne du disjoncteur, et
- soustraire à chaque première estimation ($IHT1_{i,j}$) de la température d'échauffement interne du disjoncteur, la valeur moyenne d'une pluralité d'estimations ($IHT1_{i,j}$) de la température d'échauffement interne du disjoncteur calculées à des instants différents ($T_j$), pour l'obtention d'une seconde estimation ($IHT2_{i,j}$) de la température d'échauffement interne du disjoncteur.

14. Dispositif selon l'une des revendications 11 à 13, dans lequel le circuit de contrôle est configuré pour :

- lire cycliquement et de manière synchrone, à des instants successifs ($T_j$), les valeurs d'au moins une composante ($Bz_i$) du champ magnétique mesurée par chaque magnétomètre, représentative du champ émis par la bobine du disjoncteur auquel chaque disjoncteur est associé,
- évaluer la valeur d'un courant traversant chaque disjoncteur à partir de la composante du champ magnétique mesurée.

15. Dispositif selon la revendications 14, dans lequel le circuit de contrôle est configuré pour exécuter les étapes suivantes, pour chaque disjoncteur :

- évaluer de manière cyclique le courant traversant le disjoncteur,
- calculer, dans une fenêtre temporelle glissante d'observation au moins égale aux dernières 24 heures, un taux de fonctionnement du disjoncteur qui est fonction du nombre de périodes où le disjoncteur est traversé par un courant, et de la durée de chacune de ces périodes,
- surveiller la variation du taux de fonctionnement du disjoncteur au fil du temps, dans la fenêtre temporelle glissante d'observation,
- émettre une alarme d'un troisième type (A3) si la variation du taux de fonctionnement du disjoncteur dépasse un seuil de variation déterminé.

**Patentansprüche**

1. Verfahren zum Steuern des Betriebszustands eines Leistungsschaltersatzes ($D_i$, D1-D8), wobei jeder Leistungsschalter eine Schutzspule (22) umfasst und eine Wand aufweist, durch die ein Magnetfeld ($Bx_i$, $By_i$, $Bz_i$) hindurchgeht, das von der Spule emittiert wird, wobei das Verfahren die Schritte umfasst, bestehend aus:

   - Anordnen eines synchronen dreiachsigen digitalen Magnetometers (Mi) auf einem Halbleiterchip an der Wand jedes Leistungsschalters, wobei jedes Magnetometer Magnetfeldmessmittel und einen internen Temperatursensor und einen Datenausgang umfasst, um Magnetfeld- und Temperaturmessungen bereitzustellen,

   **dadurch gekennzeichnet, dass** das Verfahren die Schritte umfasst, bestehend aus:

   - zyklischem und synchronem Lesen der von den Magnetometern bereitgestellten Temperaturen ($TM_{i,j}$) zu aufeinanderfolgenden Zeitpunkten ($T_j$),
   - Bestimmen, anhand der von den Magnetometern gemessenen Temperaturen ($TM_{i,j}$) und eines Wertes der Umgebungstemperatur ($ETA_j$), für jeden Leistungsschalter, ob eine interne Heiztemperatur ($IHT_{i,j}$) des Leistungsschalters einen ersten Temperaturschwellenwert (TT1) erreicht, der eine Anomalie des Betriebszustands des Leistungsschalters darstellen kann, und
   - Aussenden eines Alarms einer ersten Art (A1), wenn die interne Heiztemperatur ($IHT_{i,j}$) mindestens eines Leistungsschalters den ersten Temperaturschwellenwert (TT1) erreicht.

2. Verfahren nach Anspruch 1, wobei der Wert der Umgebungstemperatur ($ETA_j$) anhand der Temperaturen ($TM_{i,j}$) geschätzt wird, die von den Magnetometern gemessen wurden.

3. Verfahren nach Anspruch 2, wobei der Wert der Umgebungstemperatur ($ETA_j$) aus einem der folgenden Werte ausgewählt wird:

   - einem durchschnittlichen Temperaturwert ($TM_{i,j}$), der von den Magnetometern gleichzeitig ($T_j$) gemessen wird,
   - einem gewichteten durchschnittlichen Temperaturwert ($TM_{i,j}$), der von den Magnetometern gleichzeitig ($T_j$) gemessen wird,
   - der niedrigsten Temperatur ($TM_{i,j}$), die von den Magnetometern gleichzeitig ($T_j$) gemessen wird, oder
   - einer Kombination aus mindestens zwei der drei vorherigen Werte.

4. Verfahren nach einem der Ansprüche 1 bis 3, umfassend mindestens den ersten der folgenden zwei Schritte:

   - für jedes Magnetometer und jeden mit dem Magnetometer verbundenen Leistungsschalter, Subtrahieren des Umgebungstemperaturwertes ($ETA_j$) bei jeder von dem Magnetometer gemessenen Temperatur ($TM_{i,j}$), um eine erste Schätzung ($IHT1_{i,j}$) der internen Heiztemperatur des Leistungsschalters zu erhalten, und
   - für jedes Magnetometer und jeden mit dem Magnetometer verbundenen Leistungsschalter, Subtrahieren des Durchschnittswertes einer Vielzahl von Schätzungen ($IHT1_{i,j}$) der internen Heiztemperatur des Leistungsschalters, berechnet zu verschiedenen Zeitpunkten ($T_j$), bei jeder ersten Schätzung ($IHT1_{i,j}$) der internen Heiztemperatur des Leistungsschalters, um eine zweite Schätzung ($IHT2_{i,j}$) der internen Heiztemperatur des Leistungsschalters zu erhalten.

5. Verfahren nach einem der Ansprüche 1 bis 4, umfassend die Schritte, bestehend aus:

   - Bestimmen, für jeden Leistungsschalter, ob die interne Heiztemperatur ($IHT_{i,j}$) des Leistungsschalters einen zweiten Temperaturschwellenwert (TT1) erreicht, und
   - Aussenden eines Alarms einer zweiten Art (A2), wenn die interne Heiztemperatur ($IHT_{i,j}$) einen zweiten Temperaturschwellenwert (TT2) erreicht, der größer als der erste Temperaturschwellenwert (TT1) ist.

6. Verfahren nach einem der Ansprüche 1 bis 5, umfassend die Schritte, bestehend aus:

   - zyklischem und synchronem Lesen, zu aufeinanderfolgenden Zeitpunkten ($T_j$), der Werte mindestens einer Komponente ($Bz_i$) des von jedem Magnetometer gemessenen Magnetfelds, das das von der Spule des Leistungsschalters, der jeder Leistungsschalter zugeordnet ist, emittierte Feld darstellt, und
- Auswerten des Wertes eines Stroms ($I_{i,j}$), der durch jeden Leistungsschalter hindurchgeht, anhand der Komponente des gemessenen Magnetfelds.

7. Verfahren nach Anspruch 6, wobei der Alarm der ersten Art (A1) nur dann ausgesendet wird, wenn ein Strom durch den Leistungsschalter hindurchgeht, der unter einem Stromschwellenwert (IT1) liegt, bei dem seine interne Heiztemperatur den ersten Temperaturschwellenwert (TT1) nicht überschreiten darf.

8. Verfahren nach einem der Ansprüche 6 und 7, umfassend, wobei, wenn die internen Heiztemperaturen ($IHT_{i,j}$) von zwei benachbarten Leistungsschaltern jeweils die erste Temperaturschwelle (TT1) erreichen, der Alarm der ersten Art (A1) nicht für denjenigen der beiden Leistungsschalter ausgesendet wird, durch den über eine bestimmte Zeit kein Strom hindurchgegangen ist.

9. Verfahren nach einem der Ansprüche 6 bis 8, umfassend die Schritte, bestehend aus, für jeden Leistungsschalter:

   - zyklischem Auswerten des Stroms ($I_{i,j}$), der durch den Leistungsschalter hindurchgeht,
   - Auswerten, in einem Beobachtungszeitfenster von einigen Stunden bis zu einigen Tagen, einer Betriebsrate des Leistungsschalters, die eine Funktion der Anzahl der Zeiträume, in denen ein Strom durch den Leistungsschalter hindurchgeht, und der Dauer jeder dieser Zeiträume ist,
   - Überwachen der Schwankung der Betriebsrate des Leistungsschalters innerhalb des Beobachtungszeitfensters und
   - Aussenden eines Alarms einer dritten Art (A3), der auf eine mögliche Fehlfunktion einer vom Leistungsschalter elektrisch versorgten Ausrüstung hinweist, wenn die Schwankung der Betriebsrate des Leistungsschalters einen bestimmten Schwankungsschwellenwert überschreitet.

10. Verfahren nach Anspruch 9, umfassend, wenn die Bedingungen für das Aussenden des Alarms der ersten Art (A1) für zwei benachbarte Leistungsschalter erfüllt sind, einen Schritt, der darin besteht, die Betriebsraten jedes Leistungsschalters zu vergleichen, um den Leistungsschalter mit der höchsten Wahrscheinlichkeit einer Anomalie seines Betriebszustands zu ermitteln, wobei der Temperaturanstieg eines der Leistungsschalter möglicherweise durch den Temperaturanstieg des anderen Leistungsschalters verursacht wird, und wobei der Alarm der ersten Art (A1) nur für den Leistungsschalter mit der höchsten Wahrscheinlichkeit einer Anomalie seines Betriebszustands ausgesendet wird.

11. Vorrichtung zum Steuern des Betriebszustandes eines Leistungsschaltersatzes, wobei jeder Leistungsschalter ($D_i$) eine Schutzspule (22) umfasst und eine Wand aufweist, durch die ein Magnetfeld ($Bx_i$, $By_i$, $Bz_i$) hindurchgeht, das von der Spule emittiert wird, wobei die Vorrichtung Folgendes umfasst:

   - einen Satz von synchronen dreiachsigen digitalen Magnetometern (Mi) auf Halbleiterchips, wobei jedes Magnetometer an der Wand eines Leistungsschalters angeordnet ist und Magnetfeldmessmittel, einen internen Temperatursensor sowie einen Datenausgang umfasst, um Magnetfeld- und Temperaturmessungen bereitzustellen, und
   - eine mit den Magnetometern verbundene Steuerschaltung (MCT, SRV),

   **dadurch gekennzeichnet, dass** die Steuerschaltung (MCT, SRV) konfiguriert ist zum:

   - zyklischen und synchronen Lesen der von den Magnetometern gemessenen Temperaturen ($TM_{i,j}$) zu aufeinanderfolgenden Zeitpunkten ($T_j$),
   - Bestimmen, anhand der von den Magnetometern gemessenen Temperaturen ($TM_{i,j}$) und eines Wertes der Umgebungstemperatur ($ETA_j$), für jeden Leistungsschalter, ob eine interne Heiztemperatur ($IHT_{i,j}$) des Leistungsschalters einen ersten Temperaturschwellenwert (TT1) erreicht, der eine Anomalie des Betriebszustands des Leistungsschalters darstellen kann, und
   - Aussenden eines Alarms einer ersten Art (A1), wenn die interne Heiztemperatur ($IHT_{i,j}$) mindestens eines Leistungsschalters den ersten Temperaturschwellenwert (TT1) erreicht.

12. Vorrichtung nach Anspruch 11, wobei die Steuerschaltung so konfiguriert ist, dass sie den Wert der Umgebungstemperatur ($ETA_j$) anhand der von den Magnetometern gemessenen Temperaturen ($TM_{i,j}$) schätzt.

13. Vorrichtung nach einem der Ansprüche 11 und 12, wobei die Steuerschaltung so konfiguriert ist, dass sie für jedes Magnetometer und jeden dem Magnetometer zugeordneten Leistungsschalter mindestens den ersten der folgenden beiden Schritte ausführt:

- Subtrahieren des Umgebungstemperaturwertes (ETA$_j$) bei jeder von dem Magnetometer gemessenen Temperatur (TM$_{i,j}$), um eine erste Schätzung (IHT1$_{i,j}$) der internen Heiztemperatur des Leistungsschalters zu erhalten, und
- Subtrahieren des Durchschnittswertes einer Vielzahl von Schätzungen (IHT1$_{i,j}$) der internen Heiztemperatur des Leistungsschalters, berechnet zu verschiedenen Zeitpunkten (T$_j$), bei jeder ersten Schätzung (IHT$_{i,j}$) der internen Heiztemperatur des Leistungsschalters, um eine zweite Schätzung (IHT2$_{i,j}$) der internen Heiztemperatur des Leistungsschalters zu erhalten.

14. Vorrichtung nach einem der Ansprüche 11 bis 13, wobei die Steuerschaltung konfiguriert ist zum:

- zyklischen und synchronen Lesen, zu aufeinanderfolgenden Zeitpunkten (T$_j$), der Werte mindestens einer Komponente (Bz$_i$) des von jedem Magnetometer gemessenen Magnetfelds, das das von der Spule des Leistungsschalters, der jeder Leistungsschalter zugeordnet ist, emittierte Feld darstellt, und
- Auswerten des Wertes eines Stroms, der durch jeden Leistungsschalter hindurchgeht, anhand der Komponente des gemessenen Magnetfelds.

15. Vorrichtung nach Anspruch 14, wobei die Steuerschaltung so konfiguriert ist, dass sie für jeden Leistungsschalter die folgenden Schritte ausführt:

- zyklisches Auswerten des durch den Leistungsschalter hindurchgehenden Stroms,
- Berechnen, in einem gleitenden Beobachtungszeitfenster, das mindestens den letzten 24 Stunden entspricht, einer Betriebsrate des Leistungsschalters, die eine Funktion der Anzahl der Zeiträume, in denen ein Strom durch den Leistungsschalter hindurchgeht, und der Dauer jedes dieser Zeiträume ist,
- Überwachen der Schwankung der Betriebsrate des Leistungsschalters im zeitlichen Verlauf innerhalb des gleitenden Beobachtungszeitfensters und
- Aussenden eines Alarms einer dritten Art (A3), wenn die Schwankung der Betriebsrate des Leistungsschalters einen bestimmten Schwankungsschwellenwert überschreitet.

## Claims

1. A method of monitoring the operating state of a set of circuit breakers (D$_i$, D1-D8), each circuit breaker comprising a protective coil (22) and having a wall through which a magnetic field (Bx$_i$, By$_i$, Bz$_i$) emitted by the coil passes, the method comprising the steps of:

- arranging on the wall of each circuit breaker a synchronous triaxial digital magnetometer (M$_i$) on a semiconductor chip, each magnetometer comprising magnetic field measuring means and an internal temperature sensor, and a data output for providing magnetic field and temperature measurements,

the method **characterized in that** it comprises the steps of:

- cyclically and synchronously reading, at successive times (T$_j$), the temperatures (TM$_{i,j}$) provided by the magnetometers,
- from the temperatures (TM$_{i,j}$) measured by the magnetometers and a value of the ambient temperature (ETA$_j$), determining, for each circuit breaker, whether an internal heating temperature (IHT$_{i,j}$) of the circuit breaker reaches a first temperature threshold (TT1) which may be representative of an anomaly in the operating state of the circuit breaker, and
- emitting an alarm of a first type (A1) when the internal heating temperature (IHT$_{i,j}$) of at least one circuit breaker reaches the first temperature threshold (TT1).

2. The method according to claim 1, wherein the value of the ambient temperature (ETA$_j$) is estimated from the temperatures (TM$_{i,j}$) measured by the magnetometers.

3. The method according to claim 2, wherein the value of the ambient temperature (ETA$_j$) is selected from the following values:

- an average value of the temperatures ($TM_{i,j}$) measured at the same time ($T_j$) by the magnetometers,
- a weighted average value of the temperatures ($TM_{i,j}$) measured at the same time ($T_j$) by the magnetometers,
- the lowest of the temperatures ($TM_{i,j}$) measured at the same time ($T_j$) by the magnetometers, or
- a combination of at least two of the three previous values.

4. The method according to one of claims 1 to 3, comprising at least the first of the following two steps:

- for each magnetometer and circuit breaker associated with the magnetometer, subtracting the ambient temperature value ($ETA_j$) from each temperature ($TM_{i,j}$) measured by the magnetometer, to obtain a first estimate ($IHT1_{i,j}$) of the internal heating temperature of the circuit breaker, and
- for each magnetometer and circuit breaker associated with the magnetometer, subtracting from each first estimate ($IHT1_{i,j}$) of the internal heating temperature of the circuit breaker, the mean value of a plurality of estimates ($IHT1_{i,j}$) of the internal heating temperature of the circuit breaker calculated at different times ($T_j$), in order to obtain a second estimate ($IHT2_{i,j}$) of the internal heating temperature of the circuit breaker.

5. The method according to one of claims 1 to 4, comprising the steps of:

- determining, for each circuit breaker, whether the internal heating temperature ($IHT_{i,j}$) of the circuit breaker reaches a second temperature threshold (TT1), and
- emitting an alarm of a second type (A2) if the internal heating temperature ($IHT_{i,j}$) reaches a second temperature threshold (TT2) higher than the first temperature threshold (TT1).

6. The method according to one of claims 1 to 5 comprising the steps of:

- cyclically and synchronously reading, at successive times ($T_j$), the values of at least one component ($Bz_i$) of the magnetic field measured by each magnetometer, representative of the field emitted by the coil of the circuit breaker with which each circuit breaker is associated, and
- evaluating the value of a current ($I_{i,j}$) flowing through each circuit breaker from the measured magnetic field component.

7. The method according to claim 6, wherein the alarm of the first type (A1) is issued only if the circuit breaker has a current flowing through it that is less than a current threshold (IT1) for which its internal heating temperature should not exceed the first temperature threshold (TT1).

8. The method according to one of claims 6 and 7, wherein when the internal heating temperatures ($IHT_{i,j}$) of two adjacent circuit breakers each reach the first temperature threshold (TT1), the alarm of the first type (A1) is not issued for the one of the two circuit breakers that has not had any current flowing through it for a determined time.

9. The method according to one of claims 6 to 8, comprising the following steps for each circuit breaker:

- cyclically evaluating the current ($I_{i,j}$) flowing through the circuit breaker,
- evaluating, in an observation time window of a few hours to a few days, a rate of operation of the circuit breaker which is a function of the number of periods when the circuit breaker is crossed by a current, and the duration of each of these periods,
- monitoring the variation of the rate of operation of the circuit breaker within the observation time window, and
- issuing an alarm of a third type (A3) indicating a possible malfunction of equipment electrically supplied by the circuit breaker if the variation of the rate of operation of the circuit breaker exceeds a specified variation threshold.

10. The method according to claim 9, comprising, when the conditions for issuing the first type alarm (A1) are met for two adjacent circuit breakers, a step of comparing the operating rates of each circuit breaker to identify the circuit breaker with the higher probability of abnormality of its operating state, the temperature rise of one of the circuit breakers being caused by the temperature rise of the other circuit breaker, and wherein the alarm of the first type (A1) is issued only for the circuit breaker having the highest probability of abnormality of its operating state.

11. A device for monitoring the operating state of a set of circuit breakers, each circuit breaker ($D_i$) comprising a protective coil (22) and having a wall through which a magnetic field ($Bx_i$, $By_i$, $Bz_i$) emitted by the coil passes, the device comprising:

- a set of synchronous triaxial digital magnetometers ($M_i$) on semiconductor chips, each magnetometer being arranged on the wall of a circuit breaker and comprising magnetic field measuring means, an internal temperature sensor and a data output for providing magnetic field and temperature measurements, and
- a control circuit (MCT, SRV) connected to the magnetometers,

**characterized in that** the control circuit (MCT, SRV) is configured to:

- cyclically and synchronously read, at successive times ($T_j$), the temperatures ($TM_{i,j}$) measured by the magnetometers,
- from the temperatures ($TM_{i,j}$) measured by the magnetometers and a value of the ambient temperature ($ETA_j$), determine, for each circuit breaker, whether an internal heating temperature ($IHT_{i,j}$) of the circuit breaker reaches a first temperature threshold (TT1) which may be representative of an anomaly in the operating state of the circuit breaker, and
- emit an alarm of a first type (A1) when the internal heating temperature ($IHT_{i,j}$) of at least one circuit breaker reaches the first temperature threshold (TT1).

12. The device according to claim 11, wherein the control circuit is configured to estimate the value of the ambient temperature ($ETA_j$) from the temperatures ($TM_{i,j}$) measured by the magnetometers.

13. The device according to one of claims 11 and 12, wherein the control circuit is configured to perform at least the first of the following two steps, for each magnetometer and circuit breaker associated with the magnetometer:

- subtracting the ambient temperature value ($ETA_j$) from each temperature ($TM_{i,j}$) measured by the magnetometer, to obtain a first estimate ($IHT1_{i,j}$) of the internal heating temperature of the circuit breaker, and
- subtracting from each first estimate ($IHT1_{i,j}$) of the internal heating temperature of the circuit breaker, the average value of a plurality of estimates ($IHT1_{i,j}$) of the internal heating temperature of the circuit breaker calculated at different times ($T_j$), in order to obtain a second estimate ($IHT2_{i,j}$) of the internal heating temperature of the circuit breaker.

14. The device according to one of claims 11 to 13, wherein the control circuit is configured to:

- cyclically and synchronously read, at successive times ($T_j$), the values of at least one component ($Bz_i$) of the magnetic field measured by each magnetometer, representative of the field emitted by the coil of the circuit breaker with which each circuit breaker is associated,
- evaluate the value of a current flowing through each circuit breaker from the measured magnetic field component.

15. The device according to claim 14, wherein the control circuit is configured to perform the following steps for each circuit breaker:

- cyclically evaluating the current through the circuit breaker,
- calculating, in a sliding time window of observation at least equal to the last 24 hours, a rate of operation of the circuit breaker which is a function of the number of periods during which the circuit breaker is crossed by a current, and of the duration of each of these periods,
- monitoring the variation of the circuit breaker operating rate over time, within the sliding time window of observation,
- issuing a third type of alarm (A3) if the variation in the rate of operation of the circuit breaker exceeds a specified variation threshold.

**Fig. 1**

**Fig. 2A**

**Fig. 2B**

**Fig. 3**

TSCi,j    TAj

TMi,j → | S1 | → IHTi,j → | S2 | → A1

→ A2

MA1

**Fig. 4**

i=i+1                    j=j+1

REC(TMi,j)   S10

ETAj = LOWER_VALUE {TMi,j} (j=cte)   S11

j={j-N, j-(N-1),......, j-1, j}

IHT1i,j = TMi,j – ETAj   

IHTi,j = IHT2i,j = IHT1i,j – ($\sum$IHT1i,j)/N (i=cte)   S13

i=i+1   S12

i=i+1

**Fig. 5**

i=i+1        i=i+1

N → IHTi,j > TT2 ? → Y → A2

S20

i=i+1        i=i+1

N → IHTi,j > TT1 ? → Y → A1

S21

50'

42

SRV

NW

PC1

PRC   Vcc
      GND
      Sync →
      SW
      EBxi, EByi, EBzi
      ← 
      TMi,j

M1   M2   M3   M4   M5   M6   M7   M8

DTB

**Fig. 6**

TSCi,j     TAj

TMi,j → | S1' | → IHTi,j → | S2' | ⇢ A1

     MA2      → A2 → A3 → A4

Ii,j

**Fig. 7**

A3     A4

i=i+1     j=j+1     | S24 |

| REC(TMi,j ; Ii,j) | S10' |

| S11 |

j={j-N, j-(N-1),……, j-1, j}

| S12 | | S13 |

i=i+1     i=i+1

i=i+1     i=i+1

N    IHTi,j > TT2 ?    Y → A2

S20

**Fig. 8**

i=i+1     i=i+1

N    IHTi,j > TT1 ?    Y    Ii,j<IT1? → A1

S21     S23

**Fig. 9**

**Fig. 10**

**EP 4 226 169 B1**

## RÉFÉRENCES CITÉES DANS LA DESCRIPTION

**Documents brevets cités dans la description**

- EP 2637027 A